# EUROPÄISCHE PATENTSCHRIFT

(11) **EP 0 630 520 B1**
(45) Veröffentlichungstag und Bekanntmachung des Hinweises auf die Patenterteilung: **17.03.1999**
(21) Anmeldenummer: 93901038.5
(22) Anmeldetag: 17.12.1992
(51) Int. Cl.: H01L 21/00, B65D 55/12

(54) **SYSTEM ZUM EINSCHLEUSEN VON SUBSTRATEN IN REINSTRÄUME**
SYSTEM FOR TRANSFERRING SUBSTRATES IN CLEAN ROOMS
SYSTEME DE TRANSFERT DE SUBSTRATS DANS DES SALLES PROPRES

(30) Priorität: 09.03.1992 DE 4207341
(43) Veröffentlichungstag der Anmeldung: 28.12.1994
(60) Teilanmeldung: 97111117.4
(73) Patentinhaber: GENTISCHER, Josef, 73630 Remshalden (DE)
(72) Erfinder: GENTISCHER, Josef, 73630 Remshalden (DE)
(74) Vertreter: Dreiss, Fuhlendorf, Steimle & Becker, Patentanwälte
(86) Internationale Anmeldenummer: EP9202931
(87) Internationale Veröffentlichungsnummer: WO9318543

(56) Entgegenhaltungen:
- EP-A- 0 340 345
- WO-A-86/00870
- WO-A-90/14273
- SOLID STATE TECHNOLOGY Bd. 33, Nr. 8, August 1990, WASHINGTON US Seiten S1 - S5 CLAUDE DOCHE 'WAFER CONFINEMENT FOR CONTOL OF CONTAMINATION IN MICROELECTRONICS'

## Beschreibung

Die Erfindung betrifft ein System zum Einschleusen von Substraten in einen Reinstraum, mit einer Box zur Aufnahme einer die Substrate enthaltenden Kassette, mit einem die Box hermetisch abschließenden Boxenboden, der in der Box durch einen Verriegelungsmechanismus ver- und entriegelbar ist, wobei der Verriegelungsmechanismus eine im Boxenboden drehbar gelagerte Schwenkscheibe aufweist, die, vorzugsweise über Schubstangen, Verriegelungselemente antreibt, welche in Verriegelungsschlitze der Box eingreifen, und wobei die Schwenkscheibe Eingriffsbohrungen aufweist, in die Verriegelungsbolzen einer in einem Schleusentor angeordneten Drehscheibe eingreifen, welche von einer Antriebsvorrichtung des Systems angetrieben eine die Ver- und Entriegelung des Boxenbodens in der Box auslösende Schwenkbewegung durchführt, mit einem Aufnahmerahmen zur lagegenauen Ausrichtung der Box, und mit einem Arretiermechanismus zur Arretierung der Box im Aufnahmerahmen.

Ein derartiges System - das mit dem Fachbegriff "Standard Mechanical Interface (SMIF)" bezeichnet wird - ist aus der US-PS 4,995,430 bekannt. Der gravierende Nachteil dieses Systems ist, daß der Verriegelungsmechanismus einerseits und der Arretiermechanismus andererseits voneinander völlig getrennt ausgeführt sind. Dies bringt in nachteiliger Art und Weise mit sich, daß eine komplexe Überwachungs- und Steuerelektronik vorgesehen werden muß, welche gewährleisten soll, daß einerseits die Verriegelung des Boxenbodens in der Box erst dann gelöst wird, wenn die Box im Aufnahmerahmen arretiert ist und daß andererseits der Boxenboden in der Box verriegelt wird, bevor die Arretierung der Box im Aufnahmerahmen aufgehoben wird.

Ein weiterer Nachteil des bekannten Systems besteht darin, daß bei diesem die Antriebsvorrichtung zum Ver- und Entriegeln des Boxenbodens in der Box mittels der normgemäß hierfür vorgesehenen Drehscheibe unterhalb des Schleusentors angeordnet ist. Dies bringt in nachteiliger Art und Weise mit sich, daß das bekannte System nicht in Reinstraum-Anlagen integriert werden kann. Vielmehr muß das SMIF an die Reinstraum-Anlage angedockt werden. Zur Absenkung des Schleusentors ist dann ein separates Hubwerk erforderlich. Außerdem wird eine separate Transportvorrichtung benötigt, welche die Substrat-Kassette des bekannten Systems vom abgesenkten Schleusentor zu einem Hubwerk der Reinstraum-Anlage transportiert, von der aus dann die weitere Handhabung der Kassette mit den darin aufgenommenen Substraten stattfindet. Das bei den bekannten SMIF-Systemen erforderliche separate Hubwerk und die die Substrat-Kassette vom Hubwerk des SMIF's zum Hubwerk der Reinstraum-Anlage bewegende Transportvorrichtung verteuert und verkompliziert nachteiligerweise den Aufbau des bekannten SMIF-Systems.

Ein weiterer Nachteil liegt im komplizierten Aufbau des Verriegelungsmechanismus. Um die Kippbewegung der Verriegelungselemente am Ende des Verriegelungsvorganges des Boxenbodens in der Box zu erreichen, ist vorgesehen, daß die die Schubstangen an der Schwenkscheibe anlenkenden Bolzen in einem Nockengang der Schwenkscheibe geführt werden, womit durch eine Erhöhung des Anlenkpunktes der Schubstangen eine Kippbewegung der Verriegelungselemente erreicht wird. Eine derartige konstruktive Lösung ist nicht nur kompliziert und daher teuer in der Herstellung der Schwenkscheibe samt Nockengängen. Sie erhöht auch in nachteiliger Art und Weise die erforderliche Bauhöhe des Boxenbodens. Außerdem bringt eine derartige Konstruktion aufgrund der beim Abkippen der Verriegelungselemente auftretenden erhöhten Materialbelastung der Bolzen und des Nockengangs einen übermäßigen Verschleiß dieser Teile mit sich.

Ein weiterer Nachteil der bekannten Systeme liegt in ihrer fehlenden oder unzureichenden Berücksichtigung der lufttechnischen 3elange, die bei Reinstraum-Anlagen zur Verhinderung einer Kontamination der äußerst empfindlichen Substrate erforderlich sind. Es sind bei den bekannten Systemen keine oder nur ineffiziente Einrichtungen vorgesehen, die eventuell in den Reinstraum eingedrungenen Schwebstoffe von den Substraten fernhalten. Dieser Nachteil der bekannten Systeme wirkt sich hierbei besonders gravierend aus, da das im Reinstraum angeordnete und das Schleusentor absenkende Hubwerk selbst derartige Schwebstoffe in den Reistraum einbringt: An den reibungsbehafteten Stellen des Hubwerks entstehen nämlich Abriebpartikel, welche bei den bekannten Systemen in nachteiliger Art und Weise in den die Substrate aufnehmenden Teil des Reinstraumes gelangen.

Aus der WO 86/00870 ist ein System zum Einschleusen von Substraten in einen Reinstraum bekannt, das eine Einrichtung aufweist, die es erlaubt, den Boxenboden der die Substrate aufnehmenden Box am Schleusentor zu arretieren. Dies wird dadurch bewirkt, daß eine mit einem Federnpaar zusammenwirkende elektrische Spule vorgesehen ist, deren Aktivierung bewirkt, daß die Federn des Federnpaars die Verriegelung des Boxenbodens und der zugehörigen Box lösen und gleichzeitig den Boxenboden am Schleusentor arretieren.

Aus der Zeitschrift Solid State Technology 33 (1990) August, No. 8, pp. S1-S5, "Wafer Confinement for Control of Contamination in Microelectronics" ist es bekannt, bei einem System zum Einschleusen von Substraten in Reinsträume, also bei einem SMIF-System, den unter dem Schleusentor des Reinstraums liegenden Bereich mit Druckluft zu beaufschlagen, um damit eine Kontamination der Substrate zu verhindern. In der o.g. Druckschrift ist die Druckluftströmung nicht näher und detaillierter beschrieben. Inbesondere ist nicht offenbart, wie in dem zu spülenden Bereich des Reinstraums eine laminare Verdrängungsströmung ausgebildet werden kann.

Aus der EP-A-340 345 ist eine Vorrichtung zum Ein- und Ausschleusen von Substraten aus einem Vakuumkessel bekannt, bei dem die die Substrate aufnehmende Kassette in einen bis auf eine Luft-Abführöffnung geschlossenen Unterkasten eingesetzt wird. In diesen einen geschlossenen Käfig ausbildenden Unterkasten wird durch dessen perforierte Wände über einen Druckluftanschluß Reinstluft zugeführt, welche von einer externen Luftaufbereitungseinheit erzeugt und unter Druck zum Unterschrank geleitet wird.

Bei der bekannten Vorrichtung ist die gesamte Bewegungsmechanik in dem unter dem Schleusentor gelegenen Raum nicht gegenüber den Substraten abgeschirmt.Durch unvermeidbare Strömungsablösungen bzw. Verwirbelungen infolge der Druckluftbeaufschlagung kann eine Vermischung der Luftströmung mit Abriebpartikeln auftreten, welche die Gefahr einer Kontamination der Substrate mit sich bringt.

Die Erfindung stellt sich nun die Aufgabe, ein System der eingangs genannten Art derart weiterzubilden, daß die oben beschriebenen Nachteile vermieden werden.

Diese Aufgabe wird dadurch gelöst, daß der Arretiermechanismus mechanisch mit der Drehscheibe gekoppelt ist, derart, daß eine die Verriegelung des Boxenbodens in der Box auslösende Schwenkbewegung der Drehscheibe eine Aufhebung der Arretierung der Box im Aufnahmerahmen bewirkt, und daß eine die Entriegelung des Boxenbodens in der Box auslösende Schwenkbewegung der Drehscheibe eine Arretierung der Box im Aufnahmerahmen bewirkt.

Durch die erfindungsgemäßen Maßnahmen wird in besonders vorteilhafter Art und Weise eine Zwangsverriegelung des Boxenbodens in der Box bzw. der Box im Aufnahmerahmen erreicht. Es ist daher keine aufwendig Überwachungs- und Steuerelektronik mehr erforderlich um zu gewährleisten, daß einerseits der Boxenboden nicht entriegelt wird, wenn die Box im Aufnahmerahmen noch nicht arretiert ist oder andererseits die Arretierung der Box im Aufnahmerahmen gelöst wird, ohne daß der Boxenboden zuvor in der Box arretiert wurde. Die erfindungsgemäß vorgeschlagenen Maßnahmen bewirken daher in vorteilhafter Art und Weise, daß eine Kontamination der Substrate sicher und zuverlässig verhindert wird.

Eine vorteilhafte Weiterbildung der Erfindung sieht vor, daß die Kopplung des Arretiermechanismus und des Verriegelungsmechanismus derart erfolgt, daß eine Kurvenscheibe starr mit der Drehscheibe des Schleusenbodens verbunden ist. Die Kurvenscheibe weist Schaltkurven auf, in denen je ein Bolzen geführt ist, der mit einer weiteren Schubstange verbunden ist. Die Drehbewegung der Drehscheibe wird dadurch in eine lineare Verschiebebewegung der weiteren Schubstangen umgesetzt, durch die die Verschwenkbewegung eines an Schultern der Box ansetzenden Arretierelements gesteuert werden kann. Eine derartige mechanische Verknüpfung der Ver- bzw. Entriegelung des Boxenbodens in der Box mit der Arretierung der Box im Aufnahmerahmen zeichnet sich in besonders vorteilhafter Art und Weise durch ihrer konstruktive Einfachheit aus.

Eine weitere vorteilhafte Weiterbildung sieht vor, daß die Steuerung der Schwenkbewegung der Arretierelemente über Schaltkurven der Kurvenscheibe erfolgt, welche über einen ersten Bereich hinweg einen konstanten Radius und in einem daran anschließenden zweiten Bereich einen sich vergrößernden Radius aufweisen. Durchlaufen die mit den weiteren Schubstangen verbundenen Bolzen diesen zweiten Bereich der Schaltkurven der Kurvenscheibe, so bewirkt der sich vergrößernde Radius der Schaltkurven in besonders einfacher Art und Weise ein lineare Verschiebebewegung der weiteren Schubstangen, welche dann einen mit einem Arretierelement über einen Bolzen verbundenen Schwenkhebel beaufschlagen. Das Arretierelement wird dadurch entgegen der Federkraft einer Schwenkfeder aus seiner Arretierstellung in seine Aufnahmestellung im Aufnahmerahmen bewegt. Diese Art der Steuerung der Arretierelemente hat - außer ihrer konstruktiven Einfachheit - den Vorteil, daß nur wenig mechanische Teile benötigt werden, um die Schwenkbewegung der Arretierelemente sicher und zuverlässig auslösen und steuern zu können, wodurch sich ein derartiger Arretiermechanismus besonders einfach und billig herstellen läßt.

Eine weitere vorteilhafte Weiterbildung der Erfindung sieht vor, daß die sowohl den Arretiermechanismus als auch den Verriegelungsmechanismus antreibende Antriebsvorrichtung vollständig im Innenraum des Schleusentors angeordnet ist. Diese Maßnahme hat den Vorteil, daß das erfindungsgemäße System besonders einfach in Reinstraum-Anlagen integrierbar ist. Denn es ist bei diesem möglich, daß das Hubwerk des Reinstraumes direkt am Schleusentor ansetzen kann. Beim erfindungsgemäßen System wird somit die Absenkung des Schleusentors samt des Boxenbodens und der auf diesem aufgesetzten Substrat-Kassette durch das Hubwerk des Reinstraumes durchgeführt. Es ist daher nicht mehr - wie bei bekannten Anlagen - erforderlich, das System an den Reinstraum anzudocken und ein separates Hubwerk zum Absenken des Schleusentors sowie eine separate Transportvorrichtung zum Transport der Kassette vom Hubwerk des System zum Hubwerk des Reinstraumes vorzusehen. Diese erfindungsgemäßen Maßnahmen bewirken somit in vorteilhafter Art und Weise, daß zum einen der Einsatzbereich des erfindungsgemäßen Systems gegenüber demjenigen der bekannten Systeme vergrößert wird, da das erfindungsgemäße System in Reinstraum-Anlagen integrierbar ist. Zum anderen ist kein separates Hubwerk und keine separate Transportvorrichtung mehr notwendig, wodurch die Herstellungskosten derartiger Reinstraum-Anlagen beträchtlich gesenkt werden können.

In besonders vorteilhafter Art und Weise wird die vollständig im Innenraum des Schleusentors angeordnete Antriebsvorrichtung durch einen in einem Drehpunkt gelenkig gelagerten Bügel, einen im Bügel aufgenommenen Motor, auf dessen Motorwelle eine Gewindespindel angeflanscht ist, die in ein Gegengewinde einer Gabel eingreift, welche über einen zweiten Anlenkpunkt die starr mit der Drehscheibe des Schleusentors verbundene Kurvenscheibe anlenkt, gebildet. Dieser erfindungsgemäße Aufbau der Antriebsvorrichtung des erfindungsgemäßen Systems zeichnet sich nicht nur seinen konstruktiv einfachen Aufbau aus. Vielmehr baut er auch besonders kompakt, wodurch die Anordnung der Antriebsvorrichtung im Innenraum des Schleusentors in besonders vorteilhafter Art und Weise unkompliziert und besonders einfach ermöglicht wird.

Eine weitere vorteilhafte Weiterbildung der Erfindung stellt eine alternative Ausführungsform zu der vorstehend beschriebenen gemeinsamen Antriebsvorrichtung für den Arretier- und Verriegelungsmechanismus dar. Hierbei ist vorgesehen, daß diese Antriebsvorrichtung einen Getriebemotor aufweist, auf dessen Motorwelle eine Schnecke angeflanscht ist. Diese greift in ein Schneckenrad ein, welches mit einem Ritzel fest verbunden ist. Das Ritzel wiederum steht mit der als Stirnrad ausgebildeten Kurvenscheibe in Eingriff. Durch diese Maßnahmen wird in vorteilhafter Art und Weise erreicht, daß der Getriebemotor horizontal in das Schleusentor eingebaut werden kann, wodurch sich in vorteilhafter Art und Weise eine besonders kompakte Bauweise der erfindungsgemäßen Antriebsvorrichtung und somit eine platzsparende Ausführung des diese Antriebsvorrichtung aufnehmenden Schleusentors ergibt.

Eine weitere vorteilhafte Weiterbildung der Erfindung sieht vor, daß das Verriegelungselement des Verriegelungsmechanismus mindestens eine Kufe aufweist, welche an der Unterseite eines Gehäuses des Boxenbodens gleitet und mit einem Anschlag des Gehäuses zusammenwirkt. Dieser Anschlag begrenzt die von der Schubstange ausgelöste lineare Verschiebebewegung des Verriegelungselements in Richtung seines zugeordneten Verriegelungsschlitzes der Box und bewirkt - bei einer weiteren Bewegung der Schubstangen - in besonders vorteilhafter Art und Weise, daß ein Abkippen der Verriegelungselemente besonders einfach und materialschonend erreicht wird. Außerdem ist erfindungsgemäß vorgesehen, daß die über je ein Gelenk an der Schwenkscheibe des Boxenbodens drehbar befestigten Schubstangen bei der die Verriegelung des Boxenbodens bewirkenden Schwenkbewegung der Schwenkscheibe über den Totpunkt der Gelenke gefahren werden. Durch diese Maßnahme wird in vorteilhafter Art und Weise erreicht, daß die Verriegelung des Boxenbodens in der Box sicher und zuverläßig gegen ein selbsttätiges Öffnen gesichert ist.

Eine weitere vorteilhafte Weiterbildung der Erfindung stellt eine alternative Ausführungsform des oben beschriebenen Verriegelungsmechanismus dar. Erfindungsgemäß ist vorgesehen, daß das Verriegelungselement des Verriegelungsmechanismus mindestens einen Schieber aufweist, welcher an einem Führungselement verschiebbar geführt ist. An den Schieber ist ein drehbar gelagerter Riegel angelenkt, welcher die von der vorzugsweise als Kniehebel wirkenden Schubstange ausgelöste lineare Verschiebungsbewegung des Verriegelungselements in Richtung des zugeordneten Verriegelungsschlitzes der Box in eine Drehbewegung seines vorzugsweise schnabelförmig ausgebildeten Endes umsetzt, durch die der Boxenboden in der Box sicher und zuverlässig verriegelt wird. Durch diese erfindungsgemäße Maßnahme wird in vorteilhafter Art und Weise eine äußerst hohe Verriegelungskraft zwischen Box und Boxenboden hervorgerufen, die in einer besonders hohen Krafteinwirkung auf eine zwischen Box und Boxenboden angeordnete Dichtung resultiert.

Eine weitere vorteilhafte Weiterbildung der Erfindung sieht vor, daß eine Lüftungseinrichtung für den Reinstraum vorgesehen ist, durch welche dem Reinstraum ein die im Reinstraum aufgenommenen Substrate umströmender Reinstluftstrom zugeführt wird. Durch die erfindungsgemäß vorgesehene Lüftungseinrichtung für den Reinstraum wird in vorteilhafter Art und Weise den lufttechnischen Belangen einer derartigen Reinstraum-Anlage Rechnung getragen. Der zugeführte Reinstluftstrom bewirkt in vorteilhafter Art und Weise eine Spülung der Substrate. Die durch den Reinstluftstrom hervorgerufene Verdrängungsströmung verhindert einen Zufluß von kontaminierter Luft zu den äußerst empfindlichen Substraten, so daß eine Verunreinigung derselben durch evtl. im Reinstraum vorhandene Schwebeteilchen verhindert wird.

Vorzugsweise wird hierbei die Richtung des Reinstluftstroms parallel zur Oberfläche der zuströmenden Substrate gewählt, so daß ein turbulenzfreier Verlauf des Reinstluftstroms im Reinstraum gewährleistet ist.

Eine vorteilhafte Weiterbildung der Erfindung sieht vor, daß im Reinstraum ein Gitterelement vorgesehen ist, das in besonders vorteilhafter Art und Weise eine Verstetigung des den Reinstraum durchströmenden Reinstluftstroms bewirkt. Dieses Gitterelement ist hierbei vorzugsweise - in Strömungsrichtung des Reinstluftstroms gesehen - vor einem im Reinstraum integrierten Hubwerk angeordnet. Durch diese erfindungsgemäße Anordnung wird in vorteilhafter Art und Weise erreicht, daß dem Gitterelement außer seinen luftleittechnischen Aufgaben auch noch eine mechanische Abschirmung des das Hubwerk aufnehmenden Teils des Reinstraums zukommt, so daß bei der Hubbewegung des Hubwerks erzeugte Abriebpartikel in vorteilhafter Art und Weise nicht unmittelbar in den die Substrate aufnehmenden Teil des Reinstraums gelangen können.

Eine weitere vorteilhafte Weiterbildung der Erfindung sieht vor, daß der Reinstluftstrom nach dem Durchströmen des die Substrate aufnehmenden Teils des Reinstraums zu dem im Reinstraum integrierten Hubwerk geleitet wird. Durch die erfindungsgemäß vorgesehene Flutung des Hubwerks mit dem Reinstluftstrom werden Abriebpartikel, die an den reibungsbehafteten Teilen des Hubwerks entstehen, von dem die Substrate aufnehmenden Teile des Reinstraums ferngehalten und in vorteilhafter Art und Weise vom Reinstluftstrom abtransportiert und somit aus dem Reinstraum entfernt. Durch diese erfindungsgemäße Maßnahme wird in vorteilhafter Art und Weise eine deutliche Erhöhung der lufttechnischen Belange einer derartigen Reinstraum-Anlage erreicht.

Eine weitere vorteilhafte Weiterbildung der Erfindung sieht vor, daß in der Box eine Substrat-Fixiereinrichtung angeordnet ist, die ein mit dem Boxenboden zusammenwirkendes Scherengitter aufweist, durch das eine Hubbewegung des Boxenbodens in eine Andrückbewegung einer mit dem Scherengitter verbundenen Andrückleiste gegen die in der Kassette aufgenommenen Substrate umgesetzt wird. Durch die erfindungsgemäße Maßnahme wird eine sichere Fixierung der Substrate in der Kassette bei einem Entnahme- oder Transportvorgang der Box erreicht.

Weitere vorteilhafte Weiterbildungen ergeben sich aus den Unteransprüchen.

Weitere Einzelheiten der Erfindung sind dem Ausführungsbeispiel zu entnehmen, welches nachstehend anhand der Figuren beschrieben wird. Es zeigen:
- Figur 1: einen Schnitt durch ein erstes Ausführungsbeispiel,
- Figur 2: eine Explosionsdarstellung der Fig. 1,
- Figur 3: einen Schnitt durch einen Boxenboden des ersten Ausführungsbeispiels,
- Figur 4: einen Schnitt durch den Boxenboden entlang der Linie IV-IV der Fig. 2,
- Figur 5: einen Schnitt durch einen Aufnahmerahmen des ersten Ausführungsbeispiels,
- Figur 6: eine Draufsicht auf den Aufnahmerahmen aus der Richtung VI der Fig. 2,
- Figur 7 und 8: Teile der Arretiervorrichtung des Ausführungsbeispiels,
- Figur 9: eine Unteransicht eines Schleusentors ohne Bodenplatte des ersten Ausführungsbeispiels,
- Figur 10 und 11: einen Schnitt durch ein zweites Ausführungsbeispiel,
- Figur 12: einen Schnitt durch das zweite Ausführungsbeispiel entlang der Linie XII-XII der Fig. 10,
- Figur 13: einen Schnitt durch einen Boxenboden des zweiten Ausführungsbeispiels,
- Figur 14: einen Schnitt durch den Boxenboden entlang der Linie XIV-XIV der Fig. 13,
- Figur 15: die Einzelheit Y der Fig. 10 ohne Kassette, in vergrößertem Maßstab und entsprechend einem Schnitt entlang XV-XV der Fig. 14,
- Figur 16: eine Unteransicht eines Schleusentors ohne Bodenplatte des zweiten Ausführungsbeispiels,
- Figur 17: einen Schnitt durch die Einzelheit X der Fig. 16 entlang der Linie XVII-XVII dieser Figur in vergrößertem Maßstab.

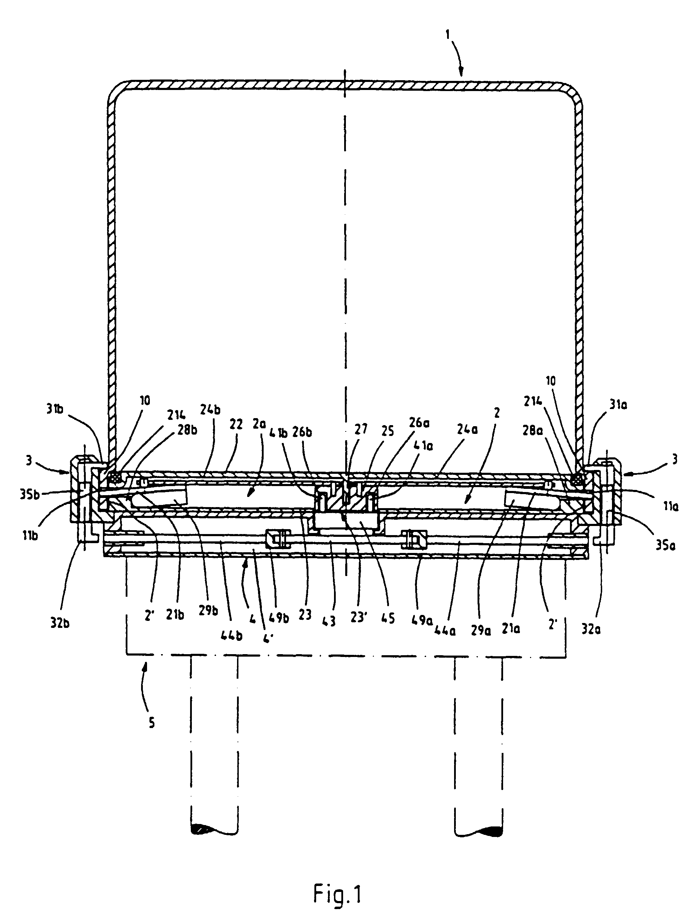

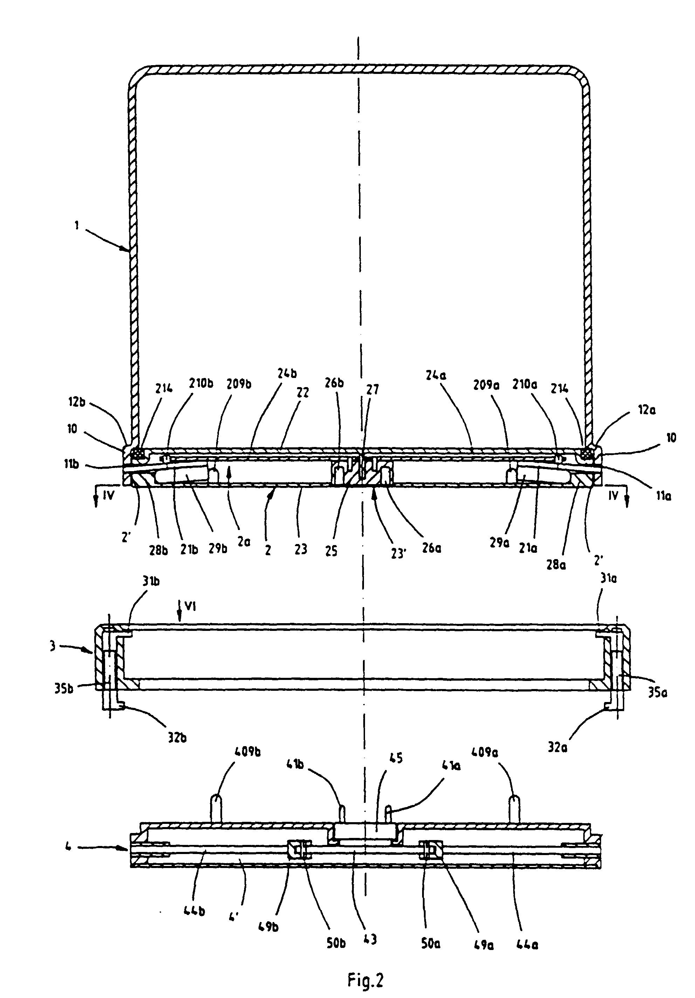

Das in den Figuren 1 und 2 dargestellte erste Ausführungsbeispiel eines Systems zum Einschleusen von Substraten in Reinsträume weist eine Box 1, einen Boxenboden 2, einen Aufnahmerahmen 3 und ein Schleusentor 4 auf. Der durch die Box 1 und den Boxenboden 2 umschlossene Raum dient in bekannter Art und Weise zur Aufnahme einer in Fig. 1 und 2 nicht dargestellten Kassette mit Substraten, welche in den nicht dargestellten, unterhalb des Schleusentors 4 gelegenen Reinstraum gebracht werden sollen.

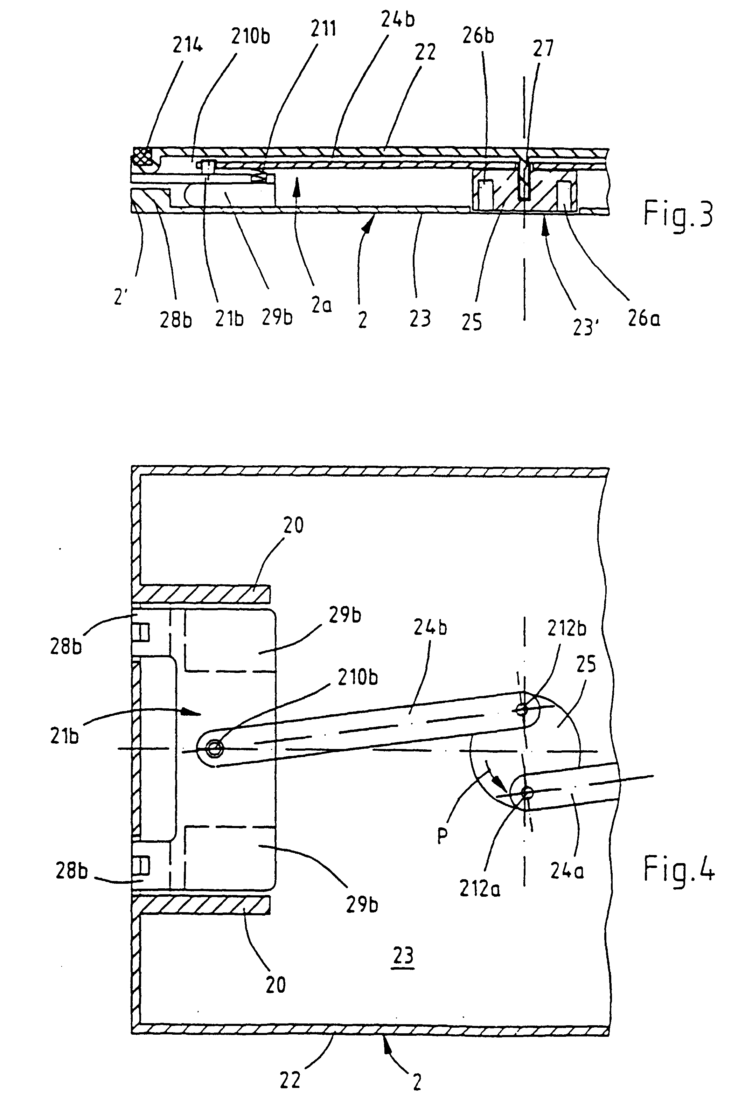

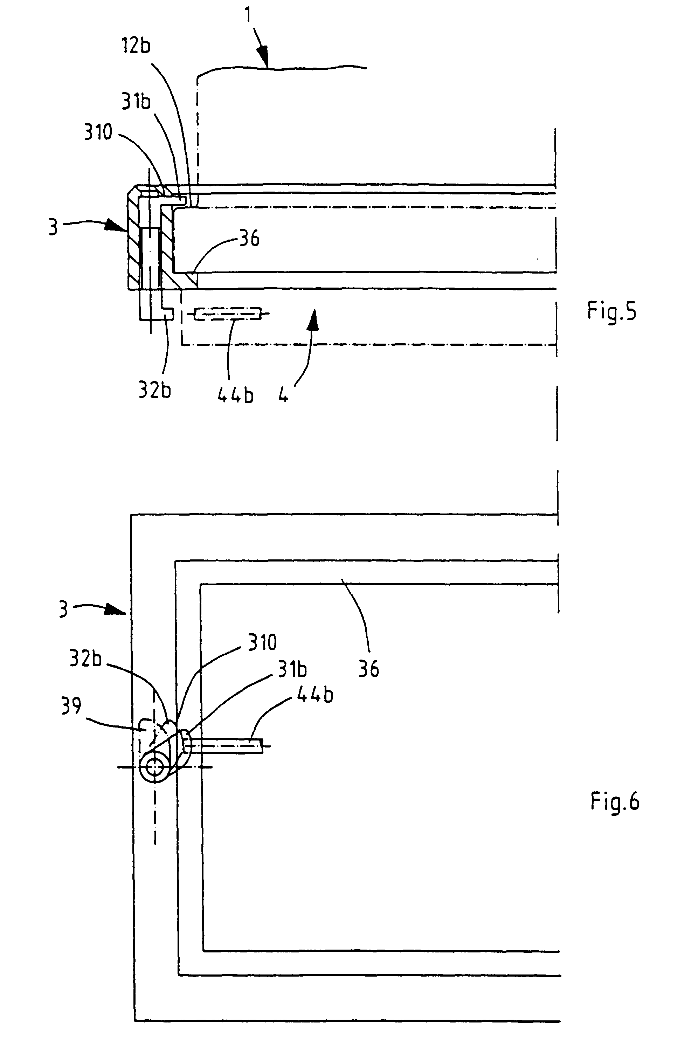

Die Box 1 weist in ihrem unteren, an den Seitenflächen 2' des Boxenbodens 2 anliegenden Bereich 10 zwei Verriegelungsschlitze 11a, 11b auf, in welche je ein Verriegelungselement 21a, 21b eines Verriegelungsmechanismus des Boxenbodens 2 eingreifen. Hierzu wird auch auf die Fig. 3 und 4 verwiesen, in denen jeweils nur die linke Hälfte des symmetrisch aufgebauten Verriegelungsmechanismus dargestellt ist. Der in einem durch ein Gehäuse 22 des Boxenbodens 2 umgrenzten Hohlraum 2a angeordnete Verriegelungsmechanismus weist eine Schwenkscheibe 25 auf, welche um einen Zapfen 27 des Gehäuses drehbar ist. An der Oberseite der Schwenkscheibe 25 ist (wie aus Fig. 4 ersichtlich ist) über je ein Gelenk 212a, 212b je ein Ende einer Schubstange 24a, 24b angelenkt, deren anderes Ende über je ein weiteres Gelenk 210a, 210b mit dem als Riegel ausgebildeten Verriegelungselement 21a, 21b verbunden ist. Jedes Verriegelungselement 21a bzw. 21b weist je zwei Kufen 29a bzw. 29b auf, die am hinteren, der Schwenkscheibe 25 zugeordneten Ende des Verriegelungselements 21a, 21b angeordnet sind und auf der Unterseite 23 des Gehäuses 22 des Boxenbodens 2 gleiten. In einer im hinteren Bereich des Verriegelungselements 21a, 21b angeordneten Vertiefung setzt je eine Druckfeder 211 an (s. Fig. 3), die sich auf der zugeordneten Schubstange 24a, 24b abstützt und verhindert, daß das Verriegelungselement 21a, 21b bei seiner durch die Drehbewegung der Schwenkscheibe 25 ausgelösten und durch die Schubstangen 24a, 24b übertragenen Verschiebebewegung auf der Unterseite 23 des Gehäuses 22 abkippt. Das Gehäuse 22 weist außerdem je zwei mit den Kufen 29a, 29b jedes Verriegelungselements 21a, 21b zusammenwirkende Anschläge 28a, 28b auf, welche die durch Führungselemente 20 (Fig. 4) des Gehäuses 22 geführte lineare Verschiebebewegung der Verriegelungselemente 21a, 21b in Richtung der Verriegelungsschlitze 11a, llb begrenzen.

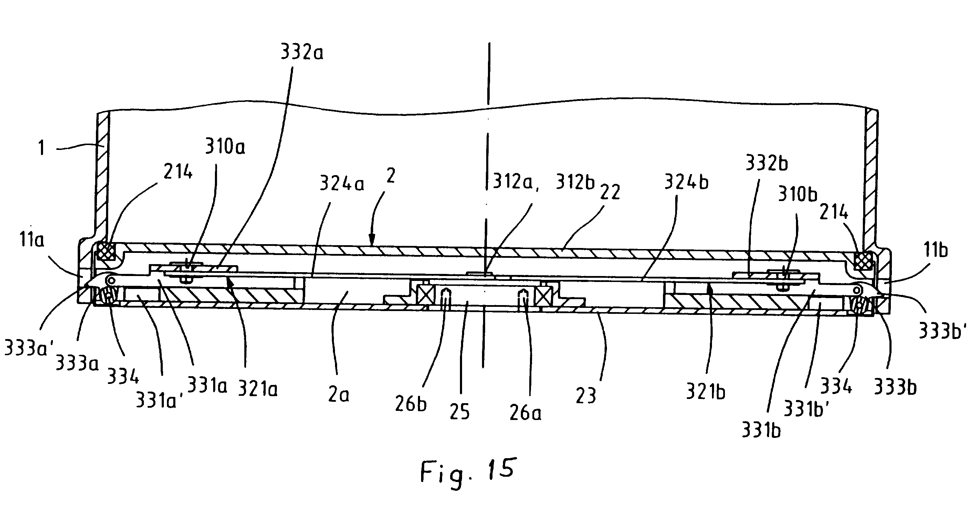

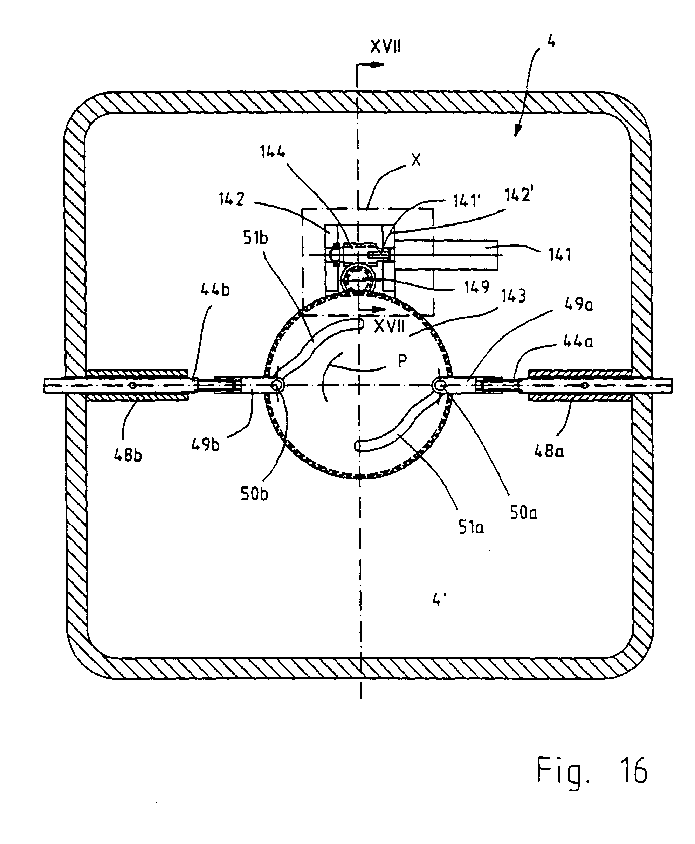

Die beschriebene Art des Antriebs der Verriegelungselemente 21a, 21b mittels der Schubstangen 24a, 24b ist nicht die einzig mögliche Konstruktionsweise. Dem Fachmann ist vielmehr aufgrund obiger Beschreibung leicht ersichtlich, welche Alternativen er einsetzen kann, um die Bewegung der Schwenkscheibe 25 in eine Ver- und Entriegelungsbewegung der Verriegelungselemente 21a, 21b umzusetzen. Beispielhafterweise wird hierzu auf die weiter unten folgende Beschreibung eines zweiten Ausführungsbeispiels und insbesondere auf die Fig. 15 und 16 verwiesen.

Die Verriegelung des Boxenbodens 2 in der Box 1 wird nun wie folgt durchgeführt: Wird die Schwenkscheibe 25 in Richtung des Pfeiles P geschwenkt, so bewegt die Schubstange 24a, 24b ihr zugeordnetes Verriegelungselement 21a, 21b nach außen. Dieses führt zunächst eine lineare Bewegung aus und greift dabei in die Verriegelungsschlitze lla, llb der Box 1 ein. Sobald die Kufen 29a bzw. 29b an die Anschläge 28a bzw. 28b stoßen, werden die Verriegelungselement 21a, 21b abgekippt. Dadurch wird eine Verspannung zwischen der Box 1 und einer entlang des gesamten Umfanges des Boxenbodens 2 laufenden Dichtung 214 hervorgerufen, wobei infolge des beim Abkippen der Verriegelungselemente 21a, 21b auftretenden Kniehebeleffekts der Schubstangen 24a, 24b in vorteilhafter Art und Weise eine besonders hohe Krafteinwirkung auf die Dichtung 214 des Boxenbodens 2 erreicht wird. Diese wird daher besonders fest gegen die Box 1 gedrückt. Durch diesen hermetischen Abschluß des von der Box 1 und des in ihr verriegelten Boxenbodens 2 abgegrenzten Raumes ist es gefahrlos möglich, die darin aufgenommene Kassette samt dem Substrat durch unreine Räume zu transportieren.

In besonders vorteilhafter Art und Weise ist vorgesehen, daß bei der Schwenkbewegung der Schwenkscheibe 25 die Schubstangen 24a, 24b über den Totpunkt der Gelenke 212a, 212b gefahren werden. Durch dieses Überschnappen erhält man eine Selbsthemmung des Verschlußmechanismus, so daß die Verriegelung des Boxenbodens 2 in der Box 1 sicher und zuverlässig gegen ein selbsttätiges Öffnen gesichert ist.

Die Unterseite 23 des Gehäuses 22 weist eine Öffnung 23' auf, so daß Verriegelungsbolzen 41a, 41b einer Drehscheibe 45 des unter dem Boxenbodens 2 angeordneten Schleusentors 4 in an der Unterseite der Schwenkscheibe 25 vorgesehene Eingriffsbohrungen 26a, 26b eintauchen können. Außerdem sind in der Unterseite 23 des Gehäuses 22 des Boxenbodens 2 mehrere, vorzugsweise drei Registrierbohrungen 209a, 209b (s. Fig. 2), die mit zugeordneten Registriervorsprüngen 409a, 409b (s. Fig. 2) des Schleusentors 4 zusammenwirken und gemeinsam mit dem Aufnahmerahmen 3 für eine lagegenaue Ausrichtung des Boxenbodens 2 und der Box 1 sorgen.

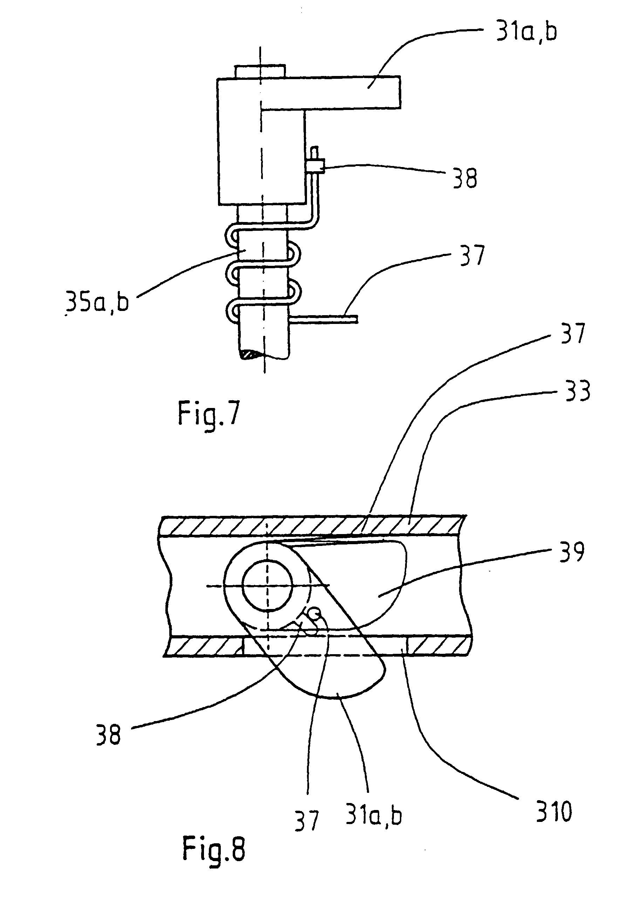

Zur Arretierung der Box 1 im Aufnahmerahmen 3 dienen Arretierelemente 31a bzw. 31b, welche an einer radial nach außen gerichteten Schulter 12a bzw. 12b der Box 1 (s. Fig. 2) angreifen. Die Arretierelemente 31a, 31b sind Bestandteile eines symmetrisch aufgebauten Arretiermechanismus, dessen linke Hälfte in den Fig. 5 bis 8 - auf die verwiesen wird - näher dargestellt sind. Im Aufnahmerahmen 3 sind zwei Ausfräsungen 39 (s. Fig. 6 und 8) angeordnet, die ein Zurückschwenken der Arretierelemente 31a, 31b aus der in den Fig. 1 und 2 dargestellten Arretierstellung in eine Aufnahmestellung erlauben, in der sie im Inneren des Aufnahmerahmens 3 positioniert sind und daher ein leichtes Einsetzen der Box 1 in den Aufnahmerahmen 3 ermöglichen. Jedes Arretierelement 31a, 31b ist - wie am besten aus Fig. 7 ersichtlich ist - auf einen Bolzen 35a, 35b aufgesetzt, welcher an seinem unteren Ende je einen Schwenkhebel 32a, 32b aufweist (Figuren 1, 2 und 5), der mit je einer aus dem Innenraum 4' des Schleusentors 4 hervortretenden weiteren Schubstange 44a, 44b zusammenwirkt. Eine Beaufschlagung der Schwenkhebel 32a, 32b durch die in Führungen 48a, 48b des Schleusentors 4 geführten weiteren Schubstangen 44a, 44b bewirkt, daß die Arretierelemente 31a, 31b entgegen der Federkraft je einer koaxial zum Bolzen 35a, 35b angeordnete Schwenkfeder 37 (Fig. 7) aus ihrer Arretierstellung, in der sie an den Schultern 12a, 12b der Box 1 angreifen und diese derart im Aufnahmerahmen (3) arretieren, durch Schlitze 310 des Aufnahmerahmens 3 hindurch in ihre Aufnahmestellung in Ausfräsungen 39 des Aufnahmerahmens 3 geschwenkt werden.

Hierbei ist vorgesehen, daß ein erstes Ende einer jeden Schwenkfeder 37 an einem radial nach innen verlaufenden Vorsprung 38 des Arretierelements 31a, 31b angreift, welcher gleichzeitig als Anschlag dient, der sich gegen das Gehäuse 33 des Aufnahmerahmens 3 abstützt und so den Schwenkwinkel der Arretierelemente 31a, 31b begrenzt (Fig. 8). Ein zweites Ende der Schwenkfeder stützt sich am Aufnahmerahmen 3 ab.

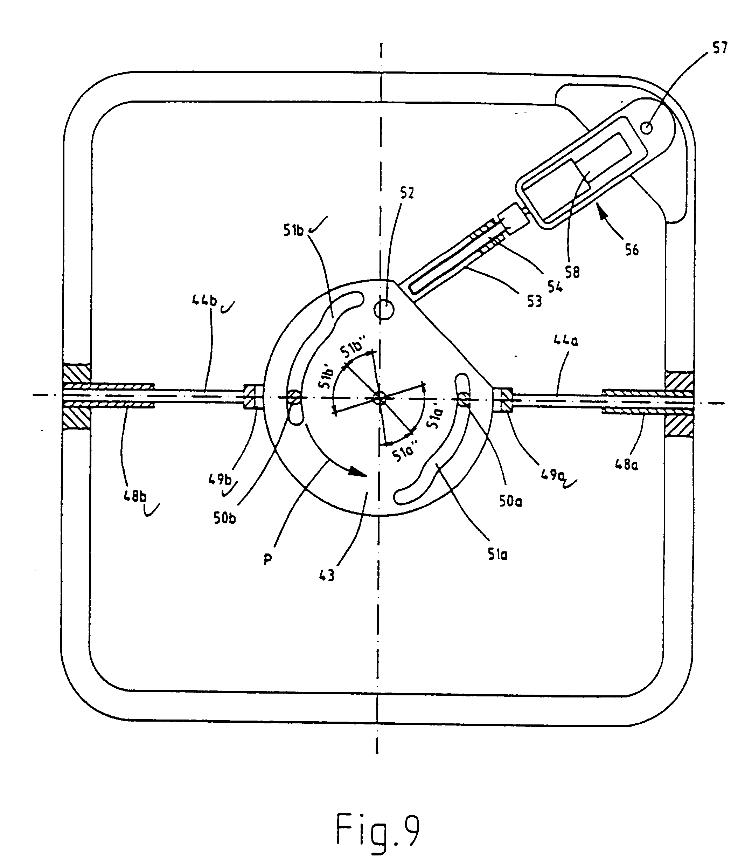

Die weiteren Schubstangen 44a, 44b sind - wie am besten aus den Fig. 1, 2 und 9 ersichtlich ist - an ihrem den Schwenkhebeln 32a, 32b abgewandten Ende mit je einer Gabel 49a, 49b versehen, die über je einen Führungsbolzen 50a, 50b in Schaltkurven 51a, 51b einer mit der Drehscheibe 45 fest verbundenen Kurvenscheibe 43 eingreifen. Hierzu wird auf die Figuren 2 bzw. 9 verwiesen. Die Schaltkurven 51a, 51b der Kurvenscheibe 43 sind dabei derart ausgebildet, daß sie in einem ersten Bereich 51a', 51b' einen konstanten Radius aufweisen. Dieser Radius ist dabei derart bemessen, daß die weiteren Schubstangen 44a, 44b die Schwenkhebel 32a, 32b nicht beaufschlagen oder - vorzugsweise - in den Innenraum 4' des Schleusentors 4 zurückgewichen sind, wenn sich die Bolzen 50a, 50b im ersten Bereich 5la', 51b' der Schaltkurven 51a, 51b der Kurvenscheibe 43 bewegen.

In einem an diesen ersten Bereich 51a', 51b' anschließenden zweiten Bereich 51a", 51b" vergrößert sich der Radius der Schaltkurven 51a, 51b, so daß bei einer weiteren Schwenkbewegung der Kurvenscheibe 43 in Richtung des Pfeiles P die über die Führungsbolzen 50a, 50b mit der Kurvenscheibe 43 verbundenen weiteren Schaltstangen 44a, 44b sich radial nach außen verschieben und die Schwenkhebel 32a, 32b beaufschlagen. Diese dadurch ausgelöste Schwenkbewegung der Schwenkhebel 32a, 32b überträgt sich über den Bolzen 35a, 35b auf die Arretierelemente 31a, 31b, wodurch diese von den Schultern 12a, 12b der Box 1 in die Ausfräsungen 39 des Aufnahmerahmens 3 zurückweichen und derart die Box 1 freigeben.

Diese Schwenkbewegung der Kurvenscheibe 43 wird durch die in Fig. 9 dargestellte Antriebsvorrichtung bewirkt, welche in besonders vorteilhafter Art und Weise im Innenraum 4' des Schleusentors 4 angeordnet ist. Diese Maßnahme bringt mit sich, daß das Hubwerk 5 (Fig. 1) des Reinstraumes direkt am Schleusentor 4 ansetzen kann. Somit wird es möglich, das beschriebene Schleusensystem als integralen Bestandteil des Reinstraumes auszubilden. Man ist daher nicht mehr - wie bei den bekannten Systemen - darauf angewiesen, dieses an den Reinstraum anzudocken und eine separate Hubvorrichtung zum Absenken des Schleusentors 4 mit samt des Boxenbodens 2 vorzusehen. Denn es ist keine außerhalb des Schleusentors 4 angeordnete und daher störende Antriebsvorrichtung für den Arretiermechanismus mehr erforderlich.

Die gemeinsame Antriebsvorrichtung für den Arretier- und den Verriegelungsmechanismus weist einen Bügel 56 auf, der in einem Drehpunkt 57 gelenkig gelagert ist. Im Bügel 56 ist ein Motor 58 mit angesetztem Getriebe aufgenommen. Auf die Motorwelle des Motors 58 ist eine Gewindespindel 54 angeflanscht, die in ein Gegengewinde einer Gabel 53 eingreift. Die Gabel 53 lenkt über einen zweiten Anlenkpunkt 52 die Kurvenscheibe 43 an.

Abschließend zum konstruktiven Aufbau des beschriebenen Systems ist anzuführen, daß die Dimensionierung und die speziellen Abmessungen dieses "Standard Mechanical Interface's" im Dokument Nr. 1872 der SEMI-Norm (Semiconductor Equipment and Materials International) angegeben sind. Auf dieses Dokument wird somit explizit Bezug genommen. Die darin nicht enthaltenen Maßangaben ergeben sich für den Fachmann zwangsläufig aus obiger Beschreibung, so daß auf eine explizite Auflistung an dieser Stelle verzichtet werden kann.

Der Funktionsablauf beim Einschleusen einer in der Box 1 hermetisch abgedichtet aufgenommenen, mit Substrat befüllten Kassette verläuft nun wie folgt:

Im Verschlußzustand des Systems zum Einschleusen von Substraten in Reinsträume wird das Schleusentor 4 vom Hubwerk 5 der Reinstraum-Anlage fest gegen den Abdeckrahmen 36 des Aufnahmerahmens 3 gepreßt, so daß der unter dem Schleusentor 4 befindliche Reinstraum hermetisch abgeschlossen ist. Die weiteren Schubstangen 44a, 44b des Schleusentors 4 sind ausgefahren und beaufschlagen die Schwenkhebel 32a, 32b des Arretiermechanismus für die Box 1. Die mit den Schwenkhebeln 32a, 32b über die Bolzen 35a, 35b verbundenen Arretierelemente 31a, 31b sind in die Ausfräsungen 39 des Aufnahmerahmens 3 zurückgewichen, so daß die Box 1 samt des in ihr mittels der Verriegelungselemente 21a, 21b des Verriegelungsmechanismus verriegelten Boxenbodens 2 in den Aufnahmerahmen 3 einsetzbar ist. Die Verriegelungsbolzen 41a, 41b der Drehscheibe 45 des Schleusentors 4 stehen in ihrer Aufnahmeposition, so daß sie beim Einsetzen der Box 1 in den Aufnahmerahmen 3 in die Eingriffsbohrungen 26a, 26b der Schwenkscheibe 25 des Boxenbodens 2 eintauchen können.

Nach dem Aufsetzen der Box wird der im Bügel 56 aufgenommene Motor 58 aktiviert, der über die Gewindespindel 54 und das in der Gabel 53 vorgesehene Gegengewinde die Kurvenscheibe 43 in Richtung des Pfeiles P in Bewegung versetzt. Durch diese Schwenkbewegung der Kurvenscheibe 43 werden die Führungsbolzen 50a, 50b entlang der zweiten Kurvenbereiche 51a", 51b" der Schaltkurven 51a, 51b in Richtung der ersten Kurvenbereiche 51a', 51b' bewegt, wodurch die weiteren Schubstangen 44a, 44b zurückgezogen werden. Die Federkraft der Schwenkfedern 37 drückt die Arretierelemente 31a, 31b durch die Schlitze 310 des Aufnahmerahmens 3 aus ihrer Aufnahmestellung in ihre Arretierstellung, so daß sie an den nach außen vorspringenden Schultern 12a, 12b der Box 1 angreifen und derart die Box 1 im Aufnahmerahmen arretieren.

Die Schwenkbewegung der Kurvenscheibe 43 wird über die Verriegelungsbolzen 41a, 41b der fest mit der Kurvenscheibe 43 verbundenen Drehscheibe 45 auf die Schwenkscheibe 25 übertragen. Dies bewirkt, daß die Schubstangen 24a, 24b zurückweichen, wodurch die Verriegelungselemente 21a, 21b des Boxenbodens 2 zurückgezogen werden und ins Innere des Gehäuses 22 des Boxenbodens 2 zurückweichen. Dadurch wird die Verriegelung des Boxenbodens 2 von der nun durch die Arretierelemente 31a, 31b fest im Aufnahmerahmen 3 gehaltenen Box 1 gelöst, wodurch der Boxenboden 2 freigegeben wird.

Mit Hilfe des Hubwerks 5 wird dann das Schleusentor 4 mitsamt des Boxenbodens 2 und der auf ihm aufgesetzten Substrat-Kassette in den Reinstraum der Anlage abgesenkt.

In der umgekehrten Richtung des Funktionsablaufs wird die entgegengesetzt (entgegen der Richtung des Pfeiles P) verlaufende Schwenkbewegung der Kurvenscheibe 43 durch die Verriegelungsbolzen 41a, 41b zuerst in eine Schwenkbewegung der Schwenkscheibe 25 umgesetzt, wodurch die Schubstangen 24a, 24b die Verriegelungselemente 21a, 21b nach außen in Richtung auf den Verriegelungsschlitz lla, llb der Box 1 hin bewegen, bis diese schließlich in die Verriegelungsschlitze lla, llb eintreten und - wie bereits oben beschrieben - den Boxenboden 2 hermetisch abdichtend in der Box 1 verriegeln. Durch eine weitere Schwenkbewegung der Kurvenscheibe 43 treten die weiteren Schubstangen 44a, 44b aus dem Gehäuse des Schleusentors 4 aus, beaufschlagen die Schwenkhebel 32a, 32b, wodurch entgegen der Verstellkraft der Schwenkfedern 37 die Arretierelemente 31a, 31b durch die Schlitze 310a, 310b des Aufnahmerahmens 3 in dessen Ausfräsungen 39 zurücktreten. Die Box 1 samt des mit ihr verriegelten Boxenbodens 2 ist nun nicht mehr im Aufnahmerahmen 3 arretiert. Sie kann deshalb leicht aus dem durch den Aufnahmerahmen 3 und das Schleusentor 4 gebildeten Schleusenbereich entnommen werden.

Das nachfolgend dargestellte zweite Ausführungsbeispiel stimmt weitgehend mit dem vorstehend beschriebenen ersten Ausführungsbeispiel überein, so daß für gleiche Teile gleiche Bezugszeichen verwendet werden können. Im Sinne einer kurzen und prägnanten Beschreibung des zweiten Ausführungsbeispiels werden deshalb auch Teile und Elemente, die schon beim ersten Ausführungsbeispiel eingehend beschrieben wurden, im folgenden nicht mehr erneut erläutert.

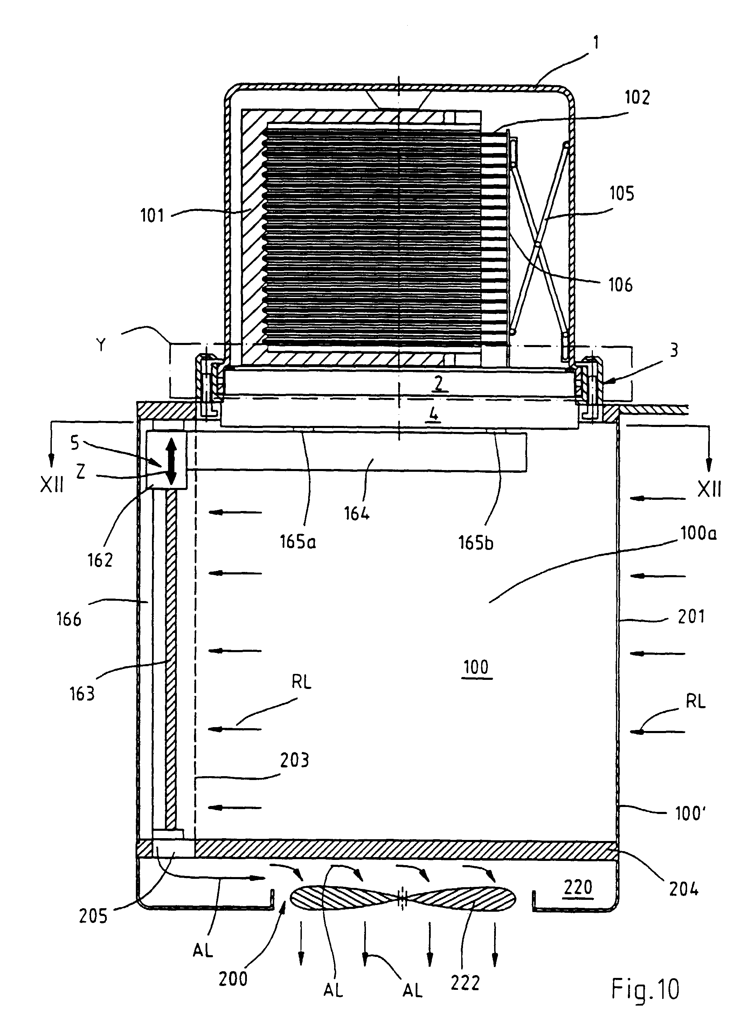

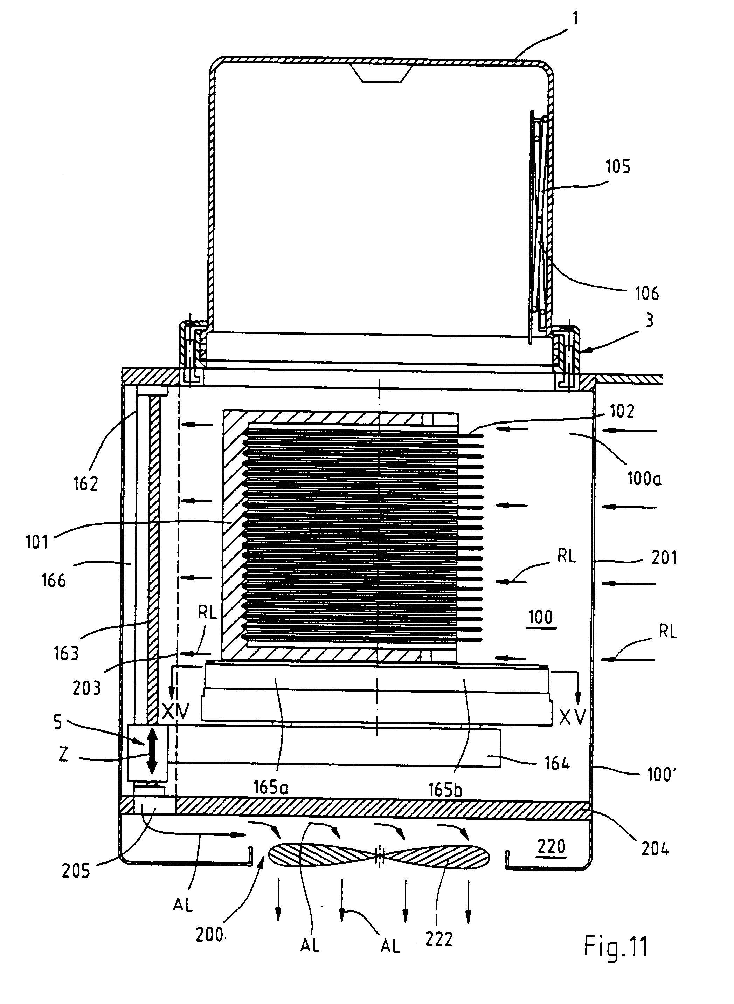

Der auf den ersten Blick ins Auge fallende Unterschied zwischen der Fig. 1 und den Fig. 10 und 11 besteht darin, daß der in Fig. 1 nicht dargestellte und bei der Erläuterung des ersten Ausführungsbeispiels nur mit Worten beschriebene, unterhalb des Schleusentors 4 gelegene Reinstraum 100 nunmehr in diesen Figuren explizit dargestellt ist. Außerdem ist in Fig. 10 und 11 eine Kassette 101 mit Substraten 102 dargestel1t, wobei in Fig. 10 die Kassette 101 in ihrer Aufnahmestellung und in Fig. 11 in ihrer in den Reinstraum 100 abgesenkten Position dargestellt ist.

Ein Unterschied zwischen dem ersten und dem zweiten Ausführungsbeispiel eines Systems zum Einschleusen von Substraten in Reinsträume besteht in einem seitlich an der Box 1 befestigten Scherengitter 105, welches über eine Andrückleiste 106 die Substrate 102 in der Kassette 101 fixiert. Dies geschieht dadurch, daß die Andrückleiste 106 des Scherengitters 105 im Verschlußzustand des Systems durch den Boxenboden 2 nach oben gedrückt wird. Dabei öffnet sich das Scherengitter 105 und schiebt die Andrückleiste 106 gegen die Substrate 102 und bewirkt damit deren Fixierung in der Kassette 101. Bei abgesenktem Boxenboden 2 legt sich dann das Scherengitter 105 mit der Andrückleiste 106 durch sein Eigengewicht an die Wand 1' der Box 1 an und gibt die Kassette 101 frei, so daß diese einfach in den Reinstraum 100 eingefahren werden kann (Fig. 11).

Durch das Scherengitter 105 und die Andrückleiste 106 wird eine Substrat-Fixiereinrichtung der Box 1 ausgebildet, welche in vorteilhafter Art und Weise eine lagefixierte Arretierung der Substrate 102 in ihrer Kassette 101 gewährleistet. Die Box 1 kann somit mit der in ihr aufgenommenen, mit Substraten 102 befüllten Kassette aus dem Aufnahmerahmen 3 entnommen und dann transportiert werden, ohne daß befürchtet werden muß, daß infolge von beim Entnahme- oder Transportvorgang auftretenden Vibrationen oder Erschütterungen die Substrate 102 aus der Kassette 101 fallen. Somit ist eine einfache Handhabung der Box 1 bei ihrer Entnahme aus dem Aufnahmerahmen 3 oder beim Transport gewährleistet, da auch eine nicht-horizontale Entnahme- oder Transportlage der Box 1 nicht zu einer Beschädigung der Substrate 102 führen kann.

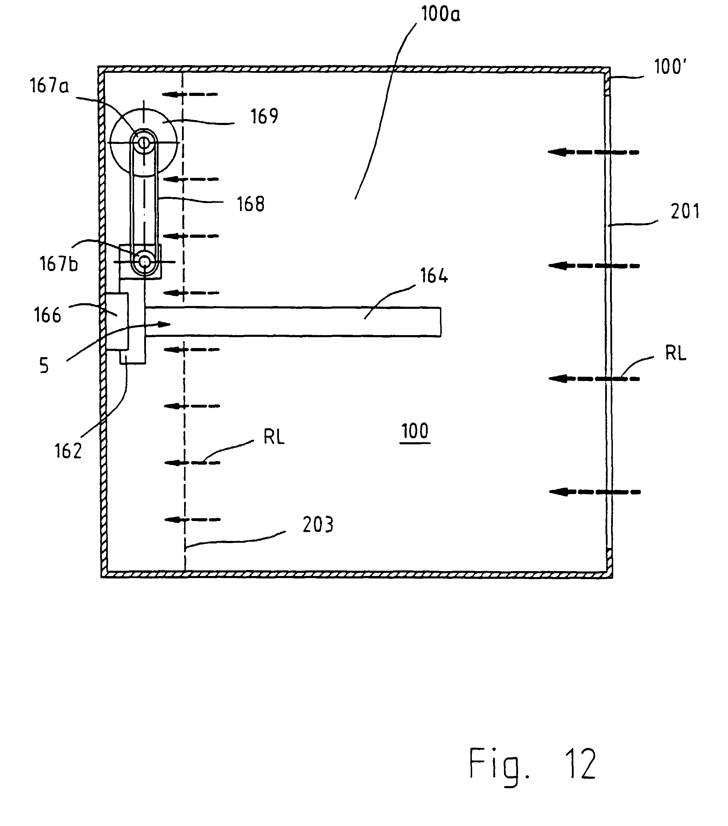

Das in den Reinstraum 100 integrierte Hubwerk 5 (siehe auch Fig. 12) weist eine elektromotorisch angetriebene Gewindespindel 163 auf, durch die ein Schlitten 162 entlang einer Führungsschiene 166 auf und ab bewegbar ist. Wie am besten aus Fig. 12 ersichtlich ist, erfolgt der Antrieb der Gewindespindel 163 durch einen Antriebsmotor 169, der über einen Riemen 168 und über Riemenscheiben 167a, 167b die in Richtung des Pfeils Z verlaufende Hubbewegung des Schlittens 162 bewerkstelligt. Ein am Schlitten 162 befestigter Tragarm 164 trägt über Nivellierbolzen 165a, 165b das Schleusentor 4.

Wichtig ist nun, daß in den Reinstraum 100 eine Lüftungseinrichtung 200 integriert ist. Hierzu weist eine Seitenwand 100' des Reinstraumes 100 eine Öffnung 201 auf, durch die Reinstluft in den Reinstraum 100 zuführbar ist. In den Fig. 10 bis 12 ist die in den Reinstraum 100 einströmende Reinstluft durch die Pfeile RL gekennzeichnet. Die zugeführte Reinstluft RL durchströmt den Reinstraum 100 und durchsetzt ein die Mechanik und den Antrieb des in den Reinstraum 100 integrierten Hubwerks abkapselndes Lochblech 203 und wird über eine Öffnung 205 des Gehäusebodens 204 des Reinstraums 100 in ein Lüftergehäuse 220 des Systems geleitet, in der eine Lüftereinheit 222 angeordnet ist.

Durch diese Zuführung von Reinstluft RL in den Reinstraum 100 wird in vorteilhafter Art und Weise den lufttechnischen Belangen eines derartigen Systems zum Einschleusen von Substraten in Reinsträume Rechnung getragen: Die vorzugsweise parallel zu den Substraten 102 einströmende Reinstluft RL bewirkt in vorteilhafter Art und Weise eine Spülung der in der Kassette 101 aufgenommenen Substrate 102 und verhindert, daß mit evtl. im Reinstraum 100 vorhandenen Schwebstoffen kontaminierte Luft zu den in der Kassette 101 aufgenommenen Substraten 102 gelangen kann. Die zugeführte Reinstluft RL bildet also eine Verdrängungsströmung aus, welche Schwebstoffe von den Substraten 102 fernhält. Das Lochblech 203 des Reinstraumes 100 bewirkt dabei eine gleichmäßige Ansaugung - also eine Verstetigung des Reinstluftstroms - der Reinstluft RL durch die Öffnung 201 des Reinstraumes 100 und garantiert außerdem eine gleichmäßige Abführung der Reinstluft RL über die Öffnung 205 des Bodens 204 des Reinstraumes 100 in das Lüftergehäuse 220.

Von Vorteil hierbei ist, daß die Lüftereinheit 222 regelbar ausgebildet ist, so daß die durch die Reinstluft RL ausgebildete und eine Spülung der Substrate 102 bewirkende Verdrängungsströmung in ihrer Geschwindigkeit den jeweils äußeren Bedingungen - im wesentlichen dem Druckgefälle zwischen einströmender und ausströmender Luft - angepaßt werden kann. Hierdurch ist gewährleistet, daß die Lüftungseinrichtung 200 des beschriebenen Systems individuellen Vorgaben der Betreiber angepaßt werden kann.

Das im Reinstraum 100 vorgesehene Lochblech 203 bewirkt - außer für den gleichmäßigen Luftstrom der Reinstluft RL im Reinstraum 100 zu sorgen - desweiteren, daß an reibungsbehafteten Elementen des Hubwerks 5 entstehende Abriebpartikel nicht unmittelbar in den die mit Substraten 102 befüllte Kassette 101 aufnehmenden Teil 100a des Reinstraums 100 gelangen können. Eine derartige Gefahr einer Kontamination des Reinstraum-Teils 100a durch Abriebpartikel wird außerdem durch die beschriebene Luftführung der Reinstluft RL eliminiert: Denn diese flutet außer dem die Substrate 102 aufnehmenden Teil 100a des Reinstraums 100 auch noch das Hubwerk 5, so daß die Abriebpartikel - wie sie bspw. bei der Bewegung des Schlittens 162 entlang der Führungsschiene 166 entstehen - sofort durch die Öffnung 205 des Gehäusebodens 204 des Reinstraums 100 in das Lüftergehäuse 220 abgeführt werden. Die symbolisch durch die Pfeile AL dargestellte Abluft des Reinstraums 100 wird also von der Lüftereinheit 222 über das Lüftergehäuse 220 abgeführt.

Es ist selbstverständlich ohne weiteres möglich, die Lüftungseinrichtung 200 des Reinstraums 100 des zweiten Ausführungsbeispiels auch beim System zum Einschleusen von Substraten gemäß dem ersten Ausführungsbeispiel einzusetzen.

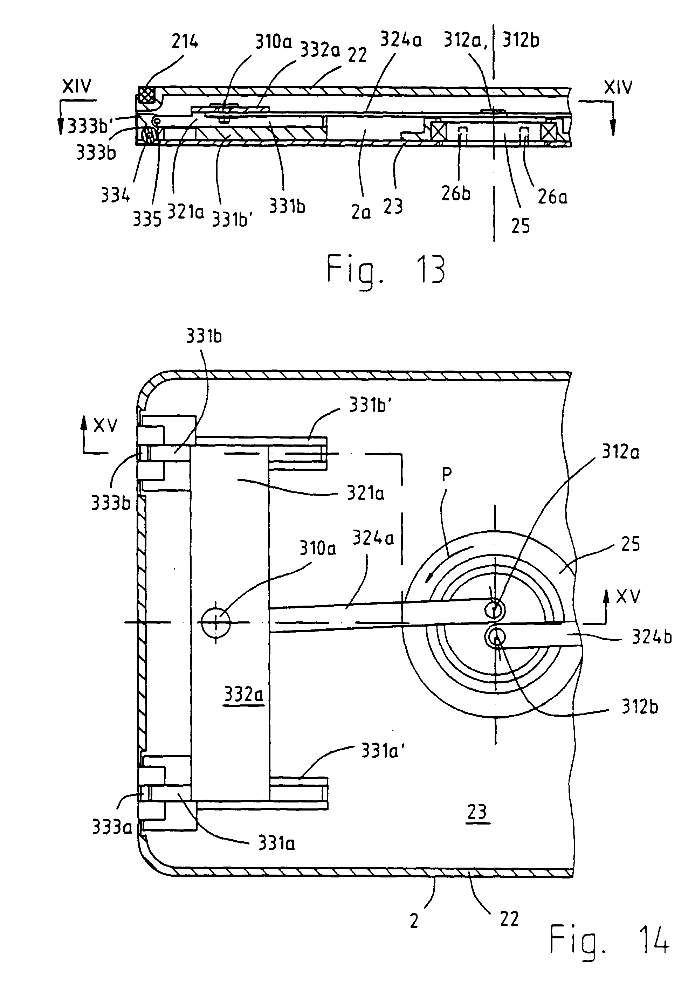

Die den Fig. 3 und 4 des ersten Ausführungsbeispiels entsprechenden Fig. 13 und 14 sowie die Fig. 15 zeigen eine zweite Ausführungsform des im Gehäuse 22 des Boxenbodens 2 angeordneten Verriegelungsmechanismus zur Fixierung des Boxenbodens 2 in der Box 1. An der Oberseite der Schwenkscheibe 25 ist - wie am besten aus Fig. 14 ersichtlich ist - über je ein Gelenk 312a, 312b je ein Ende einer Schubstange 324a, 324b angelenkt, deren anderes Ende über je ein weiteres Gelenk 310a, 310b mit einem Verriegelungselement 321a, 321b verbunden ist. Jedes Verriegelungselement 321a bzw. 321b weist zwei Schieber 331a, 331b auf, die in je einem Führungselement 331a', 331b' parallel zur Unterseite 23 des Boxenbodens 2 verschiebbar geführt und über ein Joch 332a, 332b gekoppelt sind. Mit den boxaußenseitigen Enden der Schieber 331a, 331b ist je ein in einem Drehpunkt 334 drehbar gelagerter Riegel 333a, 333b über ein weiteres Gelenk 335 verbunden.

Wird die Schwenkscheibe 25 in Richtung des Pfeiles P geschwenkt, so bewegt die Schubstange 324a, 324b ihr zugeordnetes Verriegelungselement 321a, 321b nach außen, wodurch der schnabelförmig ausgebildete Riegel 333a, 333b zu einer Drehbewegung um seinen Drehpunkt 334 gezwungen wird. Die schnabelförmigen Enden 333a', 333b' der Riegel 333a, 333b treten hierbei - wie am besten aus Fig. 15 ersichtlich ist - aus dem Gehäuse 22 des Boxenbodens 2 hervor und tauchen in die Verriegelungsschlitze 11a, 11b der Box 1 ein, die in dem unteren, an den Seitenflächen 2' des Boxenbodens 2 anliegenden Bereich 10 der Box 1 angeordnet sind. Durch diese Maßnahme wird wiederum eine sichere Verriegelung des Boxenbodens 2 in der Box 1 erreicht.

Bei der Schwenkbewegung der Schwenkscheibe 25 ist wiederum vorteilhafterweise vorgesehen, daß die Schubstangen 324a, 324b über den Totpunkt der Gelenke 312a, 312b gefahren werden. Die als Kniehebel ausgebildeten Schubstangen 324a, 324b schnappen am Ende ihrer Bewegung über ihren Totpunkt und verriegeln sich daher in vorteilhafter Art und Weise gegen selbsttätiges Öffnen. Infolge dieses bei der Verriegelungsbewegung der Riegel 333a, 333b auftretenden Kniehebeleffekts der Schubstangen 324a, 324b wird wiederum eine besonders hohe Krafteinwirkung auf die Dichtung 214 des Boxenbodens 2 erreicht, wodurch diese besonders fest gegen die Box 1 gedrückt wird. Die durch diesen Kniehebeleffekt erzeugte äußerst hohe Verriegelungskraft zwischen Box 1 und Boxenboden 2 bewirkt eine einwandfreie Abdichtung. Die in dem von der Box 1 und dem in ihr verriegelten Boxenboden 2 hermetisch abgeschlossenen Raum aufgenommene Kassette 101 mit den darin befindlichen Substraten 102 kann daher gefahrlos durch eine kontaminierte Umgebung transportiert werden.

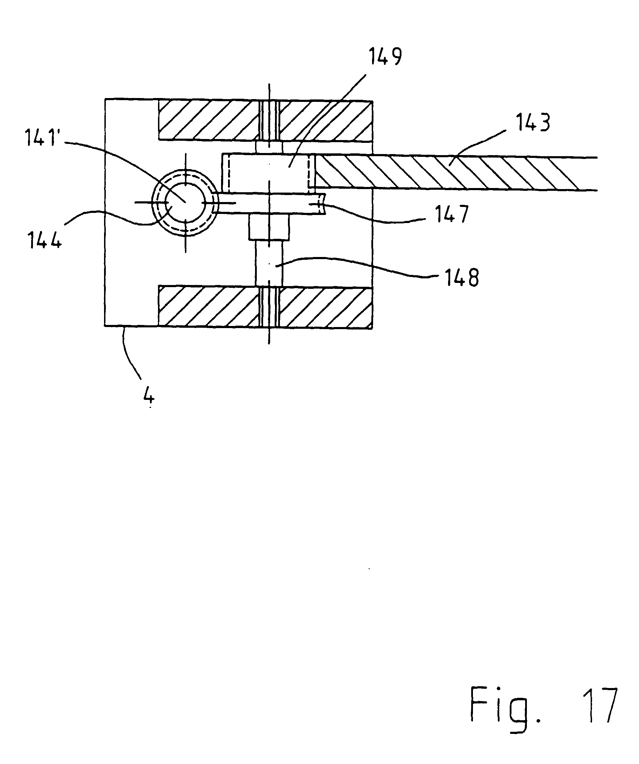

Das zweite Ausführungsbeispiel unterscheidet sich vom ersten Ausführungsbeispiel auch in der Art des Antriebs für die Drehscheibe 45 des die Box 1 samt eingesetzten Boxenbodens 2 im Aufnahmerahmen 3 arretierenden Arretiermechanismus. Hierzu wird auf die Fig. 16 und 17 verwiesen, in denen die im zweiten Ausführungsbeispiel verwendete alternative Ausführungsform des in der Fig. 9 beschriebenen Arretiermechanismus des ersten Ausführungsbeispiels gezeigt ist: Eine der Kurvenscheibe 43 der Fig. 9 entsprechende Kurvenscheibe 143 wird nun mittels eines kombinierten Schnecken-Stirnrad-Getriebes angetrieben. Die mit der Drehscheibe 45 fest verbundene Kurvenscheibe 143 ist als Stirnrad ausgebildet, mit dem ein Ritzel 149 in Eingriff steht. Das Ritzel 149 und ein mit ihm fest verbundenes Schneckenrad 147 sind auf einer senkrecht zur Unterseite 2' des Boxenbodens 2 stehenden Achse 148 gelagert. Senkrecht dazu ist auf der Motorwelle 141' eines Getriebemotors 141 eine Schnecke 144 angeordnet. Der Getriebemotor 141 und seine Motorwelle sind hierbei auf zwei Wangen 142 und 142' gelagert.

Die beschriebene Anordnung dieser gemeinsamen Antriebsvorrichtung für den Arretier- und Verriegelungsmechanismus besitzt den Vorteil, daß der Getriebemotor 141 dadurch horizontal in die Schleusentür 4 eingebaut werden kann, wodurch in besonders einfacher Art und Weise eine kompakte Bauweise derselben erreichbar ist.

## Patentansprüche

1. System zum Einschleusen von Substraten in einen Reinstraum (100), mit einer Box (1) zur Aufnahme einer die Substrate (102) enthaltenden Kassette (101), mit einem die Box (1) hermetisch abschließenden Boxenboden (2), der in der Box (1) durch einen Verriegelungsmechanismus ver- und entriegelbar ist, wobei der Verriegelungsmechanismus eine im Boxenboden (2) drehbar gelagerte Schwenkscheibe (25) aufweist, die, vorzugsweise über Schubstangen (24a,24b;324a,324b), Verriegelungselemente (21a,21b;321a,321b) antreibt, welche in Verriegelungsschlitze (11a,11b) der Box (1) eingreifen, und wobei die Schwenkscheibe (25) Eingriffsbohrungen (26a,26b) aufweist, in die Verriegelungsbolzen (41a,41b) einer in einem Schleusentor (4) angeordneten Drehscheibe (45) eingreifen, welche von einer Antriebsvorrichtung des Systems angetrieben eine die Ver- und Entriegelung des Boxenbodens (2) in der Box (1) auslösende Schwenkbewegung durchführt, mit einem Aufnahmerahmen (3) zur lagegenauen Ausrichtung der Box (1), und mit einem Arretiermechanismus zur Arretierung der Box (1) im Aufnahmerahmen (3), **dadurch gekennzeichnet,** daß der Arretiermechanismus (31a,31b; 43; 44a,44b; 49a,49b; 50a,50b; 141,144,147,148,149) mechanisch mit der Drehscheibe (45) gekoppelt ist, derart, daß eine die Verriegelung des Boxenbodens (2) in der Box (1) auslösende Schwenkbewegung der Drehscheibe (45) eine Aufhebung der Arretierung der Box (1) im Aufnahmerahmen (3) bewirkt, und daß eine die Entriegelung des Boxenbodens (2) in der Box (1) auslösende Schwenkbewegung der Drehscheibe (45) eine Arretierung der Box (1) im Aufnahmerahmen (3) bewirkt.

2. System nach Anspruch 1, dadurch gekennzeichnet, daß die Koppelung des Arretiermechanismus (31a,31b; 43; 44a,44b; 49a,49b; 50a,50b; 141,144,147,148,149) und des Verriegelungsmechanismus (21a,21b; 24a,24b; 25; 29a,29b; 209a,209b; 210a,210b; 212a,212b; 310a,310b; 312a,312b; 321a,321b; 324a,324b; 331a,331b; 331a',331b'; 332a,332b; 333a,333b; 334,335) dadurch erfolgt, daß eine Kurvenscheibe (43;143) starr mit der Drehscheibe (45) verbunden ist, daß die Kurvenscheibe (43;143) Schaltkurven (51a,51b) aufweist, in denen je ein Führungsbolzen (50a,50b) geführt ist, der jeweils mit einer weiteren Schubstange (44a,44b) verbunden ist, welche die Drehbewegung der Drehscheibe (45) in eine Verschwenkbewegung eines an Schultern (12a,12b) der Box (1) ansetzenden Arretierelements (31a,31b) umsetzt.

3. System nach Anspruch 2, dadurch gekennzeichnet, daß das Arretierelement (31a,31b) an einem Ende eines Bolzens (35a,35b) angeordnet ist, dessen anderes Ende einen Schwenkhebel (32a,32b) aufweist, der von der weiteren Schubstange (44a,44b) beaufschlagt wird, und daß koaxial zu jedem Bolzen (35a,35b) eine Schwenkfeder (37) angeordnet ist, deren erstes Ende mit dem Bolzen (35a,35b) verbunden ist, und deren zweites Ende sich am Aufnahmerahmen (3) abstützt, so daß das Arretierelement (31a,31b) bei zurückgezogener weiterer Schubstange (44a,44b) durch die Federkraft der Schwenkfeder (37) aus einer Ausfräsung (39) des Aufnahmerahmens (3) in seine Arretierstellung geschwenkt wird.

4. System nach Anspruch 2, dadurch gekennzeichnet, daß die Schaltkurven (51a,51b) der Kurvenscheibe (43;143) über einen ersten Bereich (51a',51b') hinweg einen konstanten Radius aufweisen, und daß die Schaltkurven (51a,51b) einen daran anschließenden zweiten Bereich (51a",51b") aufweisen, in dem sich der Radius der Schaltkurven (51a,51b) derart vergrößert, daß das Durchlaufen der Führungsbolzen (50a,50b) durch diesen zweiten Bereich zu einer Verschiebebewegung der weiteren Schubstangen (44a,44b) und somit zu einer Verschwenkung der Arretierelemente (31a,31b) führt.

5. System nach einem der Ansprüche 1 bis 4, dadurch gekennzeichnet, daß die sowohl den Arretiermechanismus (31a,31b; 43; 44a,44b; 49a,49b; 50a,50b; 141,144,147,148,149) als auch den Verriegelungsmechanismus (21a,21b; 24a,24b; 25; 29a,29b; 209a,209b; 210a,210b; 212a,212b; 310a,310b; 312a,312b; 321a,321b; 324a,324b; 331a,331b; 331a',331b'; 332a,332b; 333a,333b; 334,335) antreibende Antriebsvorrichtung (52,53,54,56,57,58; 141,144,147,148,149) vollständig im Innenraum (4') des Schleusentors (4) angeordnet ist.

6. System nach Anspruch 5, dadurch gekennzeichnet, daß die Antriebsvorrichtung einen in einem Drehpunkt (57) gelenkig gelagerten Bügel (56) aufweist, in dem ein Motor (58) mit angesetztem Getriebe aufgenommen ist, auf dessen Motorwelle eine Gewindespindel (54) angeflanscht ist, die in ein Gegengewinde einer Gabel (53) eingreift, welche über einen zweiten Anlenkpunkt (52) die starr mit der Drehscheibe (45) verbundene Kurvenscheibe (43) anlenkt.

7. System nach Anspruch 5, dadurch gekennzeichnet, daß die Antriebsvorrichtung einen Getriebemotor (141) aufweist, auf dessen Motorwelle (141') eine Schnecke (144) angeflanscht ist, die in ein Schneckenrad (147) eingreift, welches mit einem Ritzel (149) fest verbunden ist, und daß das Ritzel (149) mit der als Stirnrad ausgebildeten Kurvenscheibe (143) in Eingriff steht.

8. System nach Anspruch 1, dadurch gekennzeichnet, daß das Verriegelungselement (21a;21b) mindestens eine Kufe (29a;29b) aufweist, welche auf der Unterseite (23) eines Gehäuses (22) des Boxenbodens (2) gleitet, und daß ein mit der Kufe (29a,29b) zusammenwirkender Anschlag (28a,28b) vorgesehen ist, welche die von der vorzugsweise als Kniehebel wirkenden Schubstange (24a,24b) ausgelöste lineare Verschiebebewegung des Verriegelungselementes (21a,21b) in Richtung des zugeordneten Verriegelungsschlitzes (11a,11b) der Box (1) begrenzt und bei einer weiteren Bewegung der Schubstangen (24a,24b) in dieser Verschieberichtung ein Abkippen des Verriegelungselementes (21a,21b) bewirkt.

9. System nach Anspruch 1, dadurch gekennzeichnet, daß das Verriegelungselement (321a,321b) mindestens einen Schieber (331a,331b) aufweist, welcher an einem Führungselement (331a',331b') verschiebbar geführt ist, und daß der mindestens eine Schieber (331a,331b) an einem drehbar gelagerten Riegel (333a,333b) angelenkt ist, welcher die von der vorzugsweise als Kniehebel wirkenden Schubstange (324a,324b) ausgelöste lineare Verschiebungsbewegung des Verriegelungselements (321a,321b) in Richtung des zugeordneten Verriegelungsschlitzes (11a,11b) der Box (1) in eine um einen Drehpunkt (334) verlaufende Drehbewegung eines vorzugsweise schnabelförmigen Endes (333a',333b') des Riegels (333a,333b) umsetzt, durch die der Boxenboden (2) in der Box (1) verriegelt wird.

10. System nach Anspruch 8 oder 9, dadurch gekennzeichnet, daß die über je ein Gelenk (212a,212b; 312a,312b) an der Schwenkscheibe (25) angelenkten Schubstangen (24a,24b; 324a,324b) bei ihrer die Verriegelung des Boxenbodens (2) in der Box (1) bewirkenden Bewegung über den Totpunkt der Gelenke (212a,212b; 312a,312b) fahrbar sind.

11. System nach Anspruch 1, dadurch gekennzeichnet, daß eine Lüftungseinrichtung (200) für den Reinstraum (100) vorgesehen ist, durch welche diesem ein die im Reinstraum (100) aufgenommenen Substrate (102) umströmender Reinstluftstrom (RL) zuführbar ist, und durch die dieser Reinstluftstrom (RL) nach dem Umströmen mindestens der im Reinstraum (100) aufgenommenen Substrate (102) aus dem Reinstraum (100) abführbar ist.

12. System nach Anspruch 11, dadurch gekennzeichnet, daß die im Reinstraum (100) integrierte Lüftungseinrichtung (200) eine Lüftereinheit (222) zur Abführung des den Reinstraum (100) durchströmenden Reinstluftstroms (RL) aufweist.

13. System nach Anspruch 11, dadurch gekennzeichnet, daß im Reinstraum (100) ein Gitterelement (203) zur Verstetigung des den Reinstraum (100) durchströmenden Reinstluftstromes (RL) vorgesehen ist.

14. System nach Anspruch 11, dadurch gekennzeichnet, daß die Richtung des Reinstluftstroms (RL) parallel zur Oberfläche der zu umströmenden Substrate (102) verläuft.

15. System nach Anspruch 11, dadurch gekennzeichnet, daß der Reinstluftstrom (RL) nach dem Durchströmen des die Substrate (102) aufnehmenden Teils (100a) des Reinstraums (100) zu einem im Reinstraum (100) integrierten Hubwerk (5) für das Schleusentor (4) geleitet wird.

16. System nach Anspruch 13 und 15, dadurch gekennzeichnet, daß das Gitterelement (203) des Reinstraums (100) in Strömungsrichtung des Reinstluftstroms (RL) vor dem Hubwerk (5) angeordnet ist.

17. System nach Anspruch 15, dadurch gekennzeichnet, daß das das Schleusentor (4) absenkende Hubwerk (5) einen mittels einer angetriebenen Gewindespindel (163) in Hubrichtung (Z) bewegbaren Schlitten (162) aufweist, dessen Tragarm (164) am Schleusentor (4) angreift.

18. System nach Anspruch 1, dadurch gekennzeichnet, daß in der Box (1) eine Substrat-Fixiereinrichtung (105,106) angeordnet ist.

19. System nach Anspruch 18, dadurch gekennzeichnet, daß die Substrat-Fixiereinrichtung ein mit dem Boxenboden (2) zusammenwirkendes Scherengitter (105) aufweist, durch das eine Hubbewegung des Boxenbodens (2) in eine Andrückbewegung einer mit dem Scherengitter (105) verbundenen Andrückleiste (106) gegen die in der Kassette (101) aufgenommenen Substrate (102) umgesetzt wird.

## Claims

1. A system for transferring substrates into a clean room (100), having a box (1) for receiving a cassette (101) containing the substrates (102), with a box bottom (2) which hermetically seals the box (1) and which can be locked into and unlocked from the box by means of a locking mechanism, wherein the locking mechanism has a pivot disk (25) rotatably seated in the box bottom (2) which, preferably by means of push rods (24a, 24b; 324a, 324b), drives locking elements (21a, 21b; 321a, 321b) which engage locking slots (11a, 11b) in the box (1), and wherein the pivot disk (25) has engagement bores (26a, 26b) which are engaged by locking bolts (41a, 41b) of a turntable (45) disposed in a lock gate (4) and which, driven by an operating device of the system, perform a pivot movement triggering the locking and unlocking of the box bottom (2) in the box (1), having a receiving frame (3) for the positionally correct orientation of the box (1) and a detent mechanism for fixing in place the box (1) in the receiving frame (3), characterized in that the detent mechanism (31a, 31b; 43; 44a, 44b; 49a, 49b; 50a, 50b; 141, 144, 147, 148, 149) is mechanically connected with the turntable (45) in such a way that a pivot movement of the turntable (45), which triggers locking of the box bottom (2) in the box (1), causes the termination of the fixing in place of the box (1) in the receiving frame (3), and that a pivot movement of the turntable (45), which triggers the termination of the locking of the box bottom (2) in the box (1) causes the fixing in place of the box (1) in the receiving frame (3).

2. A system in accordance with claim 1, characterized in that the coupling of the detent mechanism (31a, 31b; 43; 44a, 44b; 49a, 49b; 50a, 50b; 141, 144, 147, 148, 149) and the locking mechanism ((21a, 21b; 24a, 25b; 25; 29a, 29b; 209a, 209b; 210a, 210b; 212a, 212b; 310a, 310b; 312a, 312b; 321a, 321b; 324a, 324b; 331a, 331b; 331a', 331b'; 332a, 332b; 333a,333b; 334, 335) take place in such a way that a cam plate (43; 143) is rigidly connected with the turntable (45), that the cam plate (43; 143) has control cams (51a, 51b) in each of which a guide bolt (50a, 50b) is guided which is respectively connected with a further push rod (44a, 44b), which translates the rotary motion of the turntable (45) into a pivot movement of a detent element (31a, 31b) acting on shoulders (12a, 12b) of the box (1).

3. A system in accordance with claim 2, characterized in that the detent element (31a, 31b) is disposed on one end of a bolt (35a, 35b), the other end of which has a pivot lever (32a, 32b) on which a further push rod (44a, 44b) acts, and a pivot spring (37) is disposed coaxially with each bolt (35a, 35b), the first end of which is connected with the bolt (35a, 35b) and the second end of which is supported on the receiving frame (3), so that, with the further push rod (44a,44b) retracted, the detent element (31a, 31b) is pivoted by the spring force of the pivot spring (37) out of a cutout (39) of the receiving frame (3) into its detent positions.

4. A system in accordance with claim 2, characterized in that the control cams (51a, 51b) of the cam plate (43; 143) have a constant radius over a first area (51a', 51b') and that the control cams (51a, 51b) have a following second area (51a", 51b") in which the radius of the control cams (51a, 51b) increases in such a way, that the passage of the guide bolts (50a, 50b) through this second area leads to a displacement movement of the further push rods (44a,44b) and thus to pivoting of the detent elements (31a, 31b).

5. A system in accordance with one of claims 1 to 4, characterized in that the operating device (52, 53, 54, 56, 57, 58; 141, 144, 147, 148,149) which drives the detent mechanism (31a, 31b; 43; 44a, 44b; 49a, 49b; 50a, 50b; 141, 144, 147, 148, 149) and the locking mechanism ((21a, 21b; 24a, 25b; 25; 29a, 29b; 209a, 209b; 210a, 210b; 212a, 212b; 310a, 310b; 312a, 312b; 321a, 321b; 324a, 324b; 331a, 331b; 331a', 331b'; 332a, 332b; 333a,333b; 334, 335) is completely disposed in the inner chamber (4') of the lock gate (4).

6. A system in accordance with claim 5, characterized in that the operating device has a bracket (56), which is hingedly seated in a pivot point (57), in which a motor (58) with an attached gear is received, on the motor shaft of which a threaded spindle (54) is flanged which meshes with a counter-screw thread of a fork (53) which, via a second hinge point (52), connects the cam plate (43) which is rigidly connected with the turntable (45).

7. A system in accordance with claim 5, characterized in that the operating device has a gear motor (141) on the motor shaft (141') of which a worm (144) has been flanged which engages a worm wheel (147) which is fixedly connected with a pinion (149), and that the pinion (149) is in engagement with the cam plate (143) embodied as a spur wheel.

8. A system in accordance with claim 1, characterized in that the locking element (21a, 21) has at least one runner (29a, 29b) which slides on the underside (23) of a housing (22) of the box bottom (2) and that a stop (28a, 28b) is provided which cooperates with the runner (29a, 29b) which limits the linear displacement movement of the locking element (21a, 21b), triggered by the push rod (24a, 24b) preferably embodied as a toggle lever, in the direction of an associated locking slot (11a, 11b) of the box (1) and with a further movement of the push rods (24a, 24b) in this displacement direction causes tilting of the locking element (21a, 21b).

9. A system in accordance with claim 1, characterized in that the locking element (321a, 321b) has at least one slider (331a, 331b) which is displaceably guided in a guide element (331a, 331b') and that the at least one slider (331a, 331b) is linked to a rotatably seated bar (333a, 333b), which translates the linear displacement movement of the locking element (321a, 321b) in the direction of the associated locking slot (11a, 11b) of the box (1), triggered by the push rod (324a, 324b) which preferably acts as a toggle lever, into a rotating movement around a pivot point (304) of a preferably beak-shaped end (333a', 333b') of the bar (333a, 333b), by means of which the box bottom (2) is locked in the box (1).

10. A system in accordance with claim 8 or 9, characterized in that the push rods (24a, 24b; 324a, 324b), which are each linked to the pivot disk (25) via respectively a joint (212a, 212b; 312a, 312b), can be moved beyond dead center of the joints (212a, 212b; 312a, 312b) in the course of their movement causing locking of the box bottom (2) in the box (1).

11. A system in accordance with claim 1, characterized in that a ventilating device (200) is provided for the clean room (100), by means of which a clean air flow (RL) can be supplied to it which flows around the substrates (102) contained in the clean room (100), and by means of which this clean air (RL) can be removed from the clean room (100) after it has at least flowed through the substrate (102) contained in the clean room (100).

12. A system in accordance with claim 11, characterized in that the ventilating device (200) integrated into the clean room (100) has a ventilating unit (212) for removing the clean air flow (RL) flowing through the clean room (100).

13. A system in accordance with claim 11, characterized in that a grid element (203) is provided in the clean room (100) for steadying the clean air flow (RL) flowing through the clean room (100).

14. A system in accordance with claim 11, characterized in that the direction of the clean air flow (RL) extends parallel to the surface of the substrate (102) around which it is to flow.

15. A system in accordance with claim 11, characterized in that the clean air flow (RL), after it has flowed through the section (100a) of the clean room (100) receiving the substrates (102), is guided to a lifting device (5) for the lock gate (4) integrated into the clean room (100).

16. A system in accordance with claims 13 and 15, characterized in that the grid element (203) of the clean room (100) is disposed ahead of the lifting device (5) in the direction of flow of the clean air flow (RL).

17. A system in accordance with claim 15, characterized in that the lifting device which lowers the lock gate (4) has a carriage (162) which can be moved in the lifting direction (Z) by means of a driven threaded spindle (163) and the support arm (164) of which acts on the lock gate (4).

18. A system in accordance with claim 1, characterized in that a substrate fixing device (105, 106) is disposed in the box (1).

19. A system in accordance with claim 18, characterized in that the substrate fixing device (105, 106) has a scissors brace (105) cooperating with the box bottom (2), by means of which a lifting movement of the box bottom (2) is translated into a pressing movement against the substrates (102) contained in the cassette (101) by a pressure strip (106) connected with the scissors brace (105).

## Revendications

1. Système de transfert de substrats dans une salle blanche (100), avec un boîtier (1) destiné à recevoir une cassette (101) contenant les substrats (102), avec un fond (2) obturant hermétiquement le boîtier (1), ledit fond pouvant être verrouillé et déverrouillé dans le boîtier (1) par un mécanisme de verrouillage présentant un disque oscillant (25) monté rotatif dans le fond (2) du boîtier, ledit disque oscillant actionnant, de préférence par l'intermédiaire de bielles (24a, 24b ; 324a, 324b), des éléments de verrouillage (21a, 21b ; 321a, 321b) qui s'engagent dans des fentes de verrouillage (11a, 11b) du boîtier (1), et ledit disque oscillant(25) présentant des alésages de liaison (26a, 26b) dans lesquels s'engagent des tétons de verrouillage (41a, 41b) d'un disque rotatif (45) agencé dans une porte de sas (4), ledit disque rotatif, actionné par un dispositif d'entraînement du système, décrivant un mouvement pivotant déclenchant le verrouillage et déverrouillage du fond (2) du boîtier (1), avec un cadre (3) pour l'alignement précis du boîtier (1), et avec un mécanisme de blocage pour bloquer le boîtier (1) dans le cadre (3), caractérisé en ce que le mécanisme de blocage (31a, 31b ; 43 ; 44a, 44b ; 49a, 49b ; 50a, 50b ; 141, 144, 147, 148, 149) est couplé mécaniquement au disque rotatif (45) de telle sorte qu'un mouvement pivotant du disque rotatif (45) déclenchant le verrouillage du fond (2) dans le boîtier (1) annule le blocage du boîtier (1) dans le cadre (3), et en ce qu'un mouvement pivotant du disque rotatif (45) déclenchant le déverrouillage du fond (2) dans le boîtier (1) provoque le blocage du boîtier (1) dans le cadre (3).

2. Système selon la revendication 1, caractérisé en ce que le couplage du mécanisme de blocage (31a, 31b ; 43 ; 44a, 44b ; 49a, 49b ; 50a, 50b ; 141, 144, 147, 148, 149) et du mécanisme de verrouillage (21a, 21b ; 24a, 24b ; 25 ; 29a, 29b ; 209a, 209b ; 210a, 210b ; 212a, 212b ; 310a, 310b ; 312a, 312b ; 321a, 321b ; 324a, 324b ; 331a, 331b ; 331a', 331b' ; 332a, 332b ; 333a, 333b ; 334, 335) résulte du fait qu'une came (43 ; 143) est solidaire en rotation du disque rotatif (45), que la came (43 ; 143) présente des rainures de commande (51a, 51b), chacune d'entre elles recevant un axe de guidage (50a, 50b) relié à une bielle (44a, 44b) qui transforme le mouvement pivotant du disque rotatif (45) en un mouvement pivotant d'un élément de blocage (31a, 31b) agencé sur des épaulements (12a, 12b) du boîtier (1).

3. Système selon la revendication 2, caractérisé en ce que l'élément de blocage (31a, 31b) est agencé à une extrémité d'un axe (35a, 35b) dont l'extrémité opposée présente un levier pivotant (32a, 32b) actionné par la bielle (44a, 44b), et en ce qu'un ressort de torsion (37) est agencé coaxialement à chacun des axes (35a, 35b), la première extrémité dudit ressort étant reliée à l'axe (35a, 35b), la seconde extrémité étant en appui sur le cadre (3), de sorte que l'élément de blocage (31a, 31b) est pivoté, depuis une fraisure (39) du cadre (3) vers sa position de blocage, sous l'effet du ressort de torsion (37), lorsque la bielle (44a, 44b) est en position de retrait.

4. Système selon la revendication 2, caractérisé en ce que les rainures de commande (51a, 51b) de la came (43 ; 143) présentent, sur un premier secteur (51a', 51b'), un rayon constant, et en ce qu'elles présentent un second secteur (51a', 51b") raccordé au premier, dans lequel le rayon desdites rainures de commande (51a, 51b) augmente de telle sorte que le passage des axes de guidage (50a, 50b) dans ce second secteur entraîne la translation des bielles (44a, 44b) et le pivotement des éléments de blocage (31a, 31b).

5. Système selon l'une quelconque des revendications 1 à 4, caractérisé en ce que le dispositif d'entraînement (52, 53, 54, 56, 57, 58 ; 141, 144, 147, 148, 149) actionnant tant le mécanisme de blocage (31a, 31b ; 43 ; 44a, 44b ; 49a, 49b ; 50a, 50b ; 141, 144, 147, 148, 149) que le mécanisme de verrouillage (21a, 21b ; 24a, 24b ; 25 ; 29a, 29b ; 209a, 209b ; 210a, 210b ; 212a, 212b ; 310a, 310b ; 312a, 312b ; 321a, 321b ; 324a, 324b ; 331a, 331b ; 331a', 331b' ; 332a, 332b ; 333a, 333b ; 334, 335) est entièrement agencé dans l'espace intérieur (4') de la porte de sas (4).

6. Système selon la revendication 5, caractérisé en ce que le dispositif d'entraînement présente un étrier (56) articulé en un point de rotation (57) et dans lequel est logé un moteur (58) avec un système d'engrenages intégré, une tige filetée (54) étant reliée à l'axe du moteur, ladite tige s'engageant dans le taraudage inverse d'une chape (53) qui s'articule, au niveau d'un deuxième point d'articulation (52), sur la came (43) solidaire en rotation du disque rotatif (45).

7. Système selon la revendication 5, caractérisé en ce que le dispositif d'entraînement présente un moto-réducteur (141), une vis sans fin (144) étant montée sur l'axe du moteur (141'), ladite vis s'engrenant dans une roue tangente (147), laquelle est solidaire en rotation d'un pignon (149), et en ce que le pignon (149) est engrené dans la came (143) ayant la forme d'une roue dentée droite.

8. Système selon la revendication 1, caractérisé en ce que l'élément de verrouillage (21a, 21b) présente au minimum un patin (29a ; 29b) qui glisse sur la face inférieure (23) d'un carter (22) du fond (2) du boîtier, et en ce qu'il est prévu une butée (28a, 28b) coopérant avec le patin (29a, 29b), ladite butée limitant la translation linéaire de l'élément de verrouillage (21a, 21b), déclenchée par la bielle (24a, 24b) agissant de préférence comme une genouillère, dans la direction de la fente de verrouillage correspondante (11a, 11b) du boîtier (1) et ladite butée provoquant un basculement de l'élément de verrouillage (21a, 21b), lorsque les bielles (24a, 24b) continuent leur mouvement dans cette direction de translation.

9. Système selon la revendication 1, caractérisé en ce que l'élément de verrouillage (321a, 321b) présente au minimum un coulisseau (331a, 331b) guidé en translation sur un élément de guidage (331a', 331b'), et en ce que le ou les coulisseaux (331a, 331b) est/sont articulé(s) sur un verrou (333a, 333b) monté rotatif, qui transforme la translation linéaire de l'élément de verrouillage (321a, 321b), déclenchée par la bielle (324a, 324b) agissant de préférence comme une genouillère, dans la direction de la fente de verrouillage correspondante (11a, 11b) du boîtier (1), en un mouvement rotatif d'une extrémité (333a', 333b') de préférence en forme de bec du verrou (333a, 333b) autour d'un point de rotation (334), permettant le verrouillage du fond (2) dans le boîtier (1).

10. Système selon la revendication 8 ou 9, caractérisé en ce que les bielles (24a, 24b ; 324a, 324b) articulées sur le disque oscillant (25) par une articulation respective (212a, 212b ; 312a, 312b) sont mobiles, provoquant, par leur mouvement, le verrouillage du fond (2) dans le boîtier (1) au point mort des articulations (212a, 212b ; 312a, 312b).

11. Système selon la revendication 1, caractérisé en ce qu'il est prévu un dispositif de ventilation (200) pour la salle blanche (100), par lequel un courant d'air extra-pur ventilant les substrats (102) admis dans la salle blanche (100) peut être introduit dans ladite salle, et par lequel ce courant d'air extra-pur (RL) peut être évacué de la salle blanche (100) après la ventilation au minimum des substrats (102) admis dans la salle blanche (100).

12. système selon la revendication 11, caractérisé en ce que le dispositif de ventilation (200) intégré à la salle blanche (100) présente une unité de ventilation (222) pour l'évacuation du courant d'air extra-pur (RL) traversant la salle blanche (100).

13. Système selon la revendication 11, caractérisé en ce qu'il est prévu, dans la salle blanche (100), un élément en grille (203) pour une circulation uniforme du courant d'air extra-pur (RL) traversant la salle blanche (100).

14. Système selon la revendication 11, caractérisé en ce que le courant d'air extra-pur (RL) circule parallèlement à la surface des substrats (102) à ventiler.

15. Système selon la revendication 11, caractérisé en ce que le courant d'air extra-pur (RL), après avoir traversé la partie (100a) de la salle blanche (100) recevant les substrats (102), est dirigé vers un dispositif de levage (5) intégré à la salle blanche (100) pour la porte du sas (4).

16. Système selon les revendications 13 et 15, caractérisé en ce que l'élément en grille (203) de la salle blanche (100) est agencé, dans le sens de circulation du courant d'air extra-pur (RL), devant le dispositif de levage (5).

17. Système selon la revendication 15, caractérisé en ce que le dispositif de levage (5) abaissant la porte du sas (4) présente un coulisseau (162) mobile dans la direction de levage au moyen d'une tige filetée commandée (163), la console (164) dudit coulisseau venant en contact avec la porte du sas (4).

18. Système selon la revendication 1, caractérisé en ce qu'une installation de fixation des substrats (105, 106) est agencée dans le boîtier (1).

19. Système selon la revendication 18, caractérisé en ce que l'installation de fixation des substrats présente un treillis à ciseaux (105) coopérant avec le fond (2) du boîtier et grâce auquel un mouvement de levage du fond (2) du boîtier est transformé en un mouvement de pression d'une latte de pression (106) solidaire du treillis à ciseaux (105) contre les substrats (102) disposés dans la cassette (101).
